# EUROPEAN PATENT APPLICATION

(11) **EP 4 794 466 A1**
(43) Date of publication of application: **19.08.2026**
(21) Application number: 25210022.7
(22) Date of filing: 21.10.2025
(51) Int. Cl.: H10B 12/00, G11C 5/02, G11C 5/06, G11C 8/14, G11C 11/408, H10B 80/00

(54) **MEMORY DEVICE AND MANUFACTURING METHOD THEREOF**

(30) Priority: 17.02.2025 KR 20250019908
(71) Applicant: Samsung Electronics Co., Ltd., Suwon-si, Gyeonggi-do 16677 (KR)
(72) Inventor: LEE, Changyoung, 16677 Suwon-si (KR); KANG, Kyuchang, 16677 Suwon-si (KR); PARK, Youngseok, 16677 Suwon-si (KR); SEO, Younghun, 16677 Suwon-si (KR); YOO, Changsik, 16677 Suwon-si (KR)
(74) Representative: Marks & Clerk LLP

(57) **Abstract**

A memory device includes: a cell semiconductor layer respectively including sub-cell regions arranged in a first direction, and contact regions between the sub-cell regions, wherein the sub-cell regions include memory cells; and a circuit semiconductor layer on the cell semiconductor layer and including a circuit configured to control the memory cells. The cell semiconductor layer includes: sub-wordlines extending in the first direction from the sub-cell regions to adjacent contact regions; odd wordline interconnection lines extending from an odd sub-cell region to adjacent contact regions; and even wordline interconnection lines extending from an even sub-cell region to the adjacent contact regions.

## Description

### BACKGROUND

The present disclosure relates to a memory device and a manufacturing method thereof.

To address demand for miniaturization, multi-functionalization, and highperformance of electronic products, high-capacity integrated circuit devices are required. As the feature size of memory devices such as dynamic random access memory (DRAM) devices decreases, efficient arrangement of circuits for driving the memory devices is required.

In order to reduce the area of the memory device, cell wafers and circuit wafers are manufactured, and may be stacked, such as in a Cell-on-Peri (CoP) or Peri-on-Cell (PoC) structure. For example, when sub-wordline drivers, bitline sense amplifiers, and other circuits corresponding to each sub-cell are disposed in an area corresponding to each sub-cell of the cell wafer in the circuit wafer, the area of the memory device may be reduced.

### SUMMARY

One or more example embodiments provide a semiconductor device that may improve the driving capability of a wordline while also improving the efficiency of an interconnection line. One or more example embodiments may provide a semiconductor memory device including memory cells, such as a dynamic random access memory (DRAM) device. Nevertheless, the embodiments described herein are not limited to DRAM devices, and may relate to any type of semiconductor device, and more specifically, to any type of semiconductor memory device.

According to an aspect of an example embodiment, a memory device, includes: a cell semiconductor layer respectively including a plurality of sub-cell regions arranged in a first direction, and a plurality of contact regions between the plurality of sub-cell regions, wherein the plurality of sub-cell regions includes a plurality of memory cells; and a circuit semiconductor layer stacked with (e.g., forming a stack (e.g., in a third direction) with) the cell semiconductor layer and including a circuit configured to control the plurality of memory cells. The cell semiconductor layer includes: sub-wordlines extending in the first direction from the plurality of sub-cell regions to adjacent contact regions, wherein the sub-wordlines are spaced apart along a second direction intersecting the first direction; and wordline interconnection lines. The wordline interconnection lines include: odd wordline interconnection lines extending from an odd sub-cell region, among the plurality of sub-cell regions, to the adjacent contact regions, the odd wordline interconnection lines overlapping, in a third direction, odd sub-wordlines in the odd sub-cell region and odd sub-wordlines in even sub-cell regions adjacent to the odd sub-cell region in the first direction, wherein the third direction intersects the first direction and the second direction; and even wordline interconnection lines extending from an even sub-cell region, among the plurality of sub-cell regions, to the adjacent contact regions, the even wordline interconnection lines overlapping, in the third direction, even sub-wordlines in the even sub-cell region and even sub-wordlines in odd sub-cell regions adjacent to the even sub-cell region in the first direction.

According to another aspect of an example embodiment, a memory device, includes: a plurality of sub-cell regions respectively including a plurality of memory cells and arranged in a first direction; a plurality of contact regions between the plurality of sub-cell regions; a plurality of sub-wordlines extending in the first direction from the plurality of sub-cell regions to adjacent contact regions, wherein the plurality of sub-wordlines are spaced apart along a second direction intersecting the first direction; and a plurality of wordline interconnection lines that overlap at least some of the plurality of sub-cell regions, wherein the plurality of wordline interconnection lines extend in the first direction from the at least some of the plurality of sub-cell regions to the adjacent contact regions and overlap sub-wordlines adjacent to overlapping sub-wordlines in the first direction, in the adjacent contact regions. At least some of the plurality of wordline interconnection lines are connected to the overlapping sub-wordlines in the adjacent contact regions, and the plurality of wordline interconnection lines are connected to sub-wordline drivers that overlap at least some of the plurality of sub-cell regions.

According to another aspect of an example embodiment, a manufacturing method of a memory device, including: forming a cell structure layer including a memory cell structure having sub-wordlines extending in a first direction in a plurality of sub-cell regions defined on a first substrate, wherein the sub-wordlines are spaced apart in a second direction, intersecting the first direction; inverting the cell structure layer and grinding the first substrate; forming a cell interconnection layer including wordline interconnection lines alternately overlapping sub-wordlines in the first direction and the second direction in the plurality of sub-cell regions, the wordline interconnection lines extending to adjacent contact regions to overlap adjacent sub-wordlines, on an upper surface of the cell structure layer; forming a circuit element layer by forming sub-wordline drivers in a plurality of unit areas defined on a second substrate; forming a circuit interconnection layer on an upper surface of the circuit element layer; and bonding the cell interconnection layer and the circuit interconnection layer so that the plurality of sub-cell regions and the plurality of unit areas overlap each other.

According to one or more example embodiments, because wordline interconnection lines connected to a sub-wordline driver may be connected to the sub-wordline in a contact region of both ends of a sub-cell region, the sub-wordline may be driven at both ends, and the driving capability of the sub-wordline may be improved.

According to one or more example embodiments, because one wordline interconnection line is connected to sub-wordlines of neighboring sub-cell regions, the wordline interconnection lines are disposed alternately, and bitline interconnection lines may be disposed in a region in which the wordline interconnection lines are not disposed. That is, the interconnection efficiency of the sub-cell region may be improved.

According to one or more example embodiments, because a gap between the wordline interconnection lines may increase, the coupling capacitance between the wordline interconnection lines may be reduced, and the risk of short-circuit failures between the wordline interconnection lines may be reduced.

At least some of the above and other features of the invention are set out in the claims.

The aspects to be solved by the present disclosure are not limited to the above-mentioned aspects, and other aspects not mentioned herein will be clearly understood by those skilled in the art from the following description.

### BRIEF DESCRIPTION OF DRAWINGS

The above and other aspects, features, and advantages will be more apparent from the following description of example embodiments, taken in conjunction with the accompanying drawings, in which:
FIG. 1 is a view illustrating a circuit structure of a memory device according to an example embodiment;
FIG. 2 is a perspective view illustrating a memory device according to an example embodiment;
FIG. 3 is a perspective view illustrating a portion of a memory device described with reference to FIG. 2;
FIG. 4 is a view illustrating a bonding surface of a memory device according to an example embodiment;
FIG. 5A is a cross-sectional view including line I-I' of FIG. 3, and FIG. 5B is a cross-sectional view including line II-II' of FIG. 3;
FIG. 6 is a view illustrating a structure of a memory cell array and a core control circuit of a memory device according to an example embodiment;
FIGS. 7A and 7B are cross-sectional views of FIG. 6 taken along a wordline;
FIGS. 8 and 9 are views illustrating a structure of a memory cell region and a core control circuit of a memory device according to an example embodiment;
FIGS. 10A, 10B and 10C are views illustrating a structure of a core control circuit according to example embodiments;
FIG. 11 is a diagram illustrating a structure of a memory cell array and a core control circuit of a memory device according to example embodiments;
FIGS. 12A and 12B are cross-sectional views of FIG. 11 taken along a wordline;
FIG. 13 is a view illustrating a structure of a memory cell array and a core control circuit of a memory device according to example embodiments;
FIGS. 14A and 14B are cross-sectional views of FIG. 13 taken along a wordline;
FIG. 15 is a view illustrating a structure of a memory cell array and a core control circuit of a memory device according to example embodiments;
FIGS. 16A, 16B and 16C are cross-sectional views of FIG. 15 taken along a wordline;
FIGS. 17 and 18 are perspective views illustrating a memory device according to an example embodiment;
FIG. 19 is a perspective view illustrating a memory cell structure of a memory device according to an example embodiment; and
FIG. 20 is a flow chart illustrating a manufacturing method of a memory device according to an example embodiment.

### DETAILED DESCRIPTION

Hereinafter, example embodiments will be described with reference to the accompanying drawings. Like components are denoted by like reference numerals throughout the specification, and repeated descriptions thereof are omitted. Each embodiment provided in the following description is not excluded from being associated with one or more features of another example or another embodiment also provided herein or not provided herein but consistent with the present disclosure.

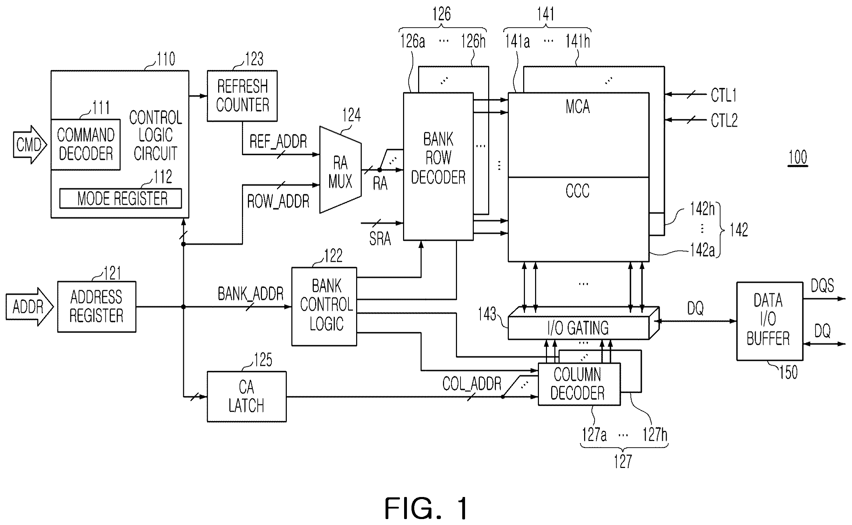

FIG. 1 is a view illustrating a circuit structure of a memory device according to an example embodiment.

Referring to FIG. 1, a memory device 100 may include various circuits, including a control logic circuit 110, an address register 121, a bank control logic (i.e., bank control circuit) 122, a refresh counter 123, a row address multiplexer 124, a column address latch 125, a row decoder 126, a column decoder 127, a memory core circuit 141, a sense amplifier 142, an input/output gating circuit 143, and a data input/output buffer 150.

The memory core circuit 141 may include a plurality of memory core circuits 141a to 141h. Additionally, a plurality of row decoders (126: 126a-126h), a plurality of column decoders (127: 127a-127h), and a plurality of sense amplifiers (142: 142a-142h) may be respectively connected to the plurality of memory core circuits 141a to 141h.

Each of the plurality of memory core circuits 141a to 141h, the plurality of sense amplifiers 142a to 142h, the plurality of column decoders 127a to 127h, and the plurality of row decoders 126a to 126h may respectively form a plurality of banks.

Each of the plurality of memory core circuits 141a to 141h may include a memory cell array MCA and a core control circuit CCC. The memory cell array MCA may include a plurality of wordlines, a plurality of bitlines, and a plurality of memory cells connected to the plurality of wordlines and the plurality of bitlines.

The core control circuit CCC may include circuits configured to control the memory cell array MCA. For example, the core control circuit CCC may include a sub-wordline driver circuit for driving the plurality of wordlines, and a bitline sense amplifier circuit for detecting a voltage change of the plurality of bitlines and amplifying the voltage change.

The address register 121 may receive an address ADDR including a bank address BANK_ADDR, a row address ROW_ADDR, and a column address COL_ADDR from a memory controller connected to the memory device 100. The address register 121 may provide the received bank address BANK_ADDR to the bank control logic 122, may provide the received row address ROW_ADDR to the row address multiplexer 124, and may provide the received column address COL_ADDR to the column address latch 125.

The bank control logic 122 may generate bank control signals in response to the bank address BANK_ADDR. In response to the bank control signals, a row decoder corresponding to the bank address BANK_ADDR, among a plurality of row decoders 124a to 124h, may be activated, and a column decoder corresponding to the bank address BANK_ADDR, among the plurality of column decoders 127a to 127h, may be activated.

The row address multiplexer 124 may receive the row address ROW_ADDR from the address register 121, and may receive a refresh row address REF_ADDR from the refresh counter 123. The row address multiplexer 124 may selectively output the row address ROW_ADDR or the refresh row address REF_ADDR as a row address RA. The row address RA output from the row address multiplexer 124 may be applied to each of the plurality of row decoders 126a to 126h.

The refresh counter 123 may sequentially increase or decrease the refresh row address REF_ADDR according to the control of the control logic circuit 110.

Among the plurality of row decoders 126a to 126h, a row decoder activated by the bank control logic 122 may decode the row address RA output from the row address multiplexer 124 and may activate a wordline corresponding to the row address. For example, the activated row decoder may apply a wordline driving voltage to the wordline corresponding to the row address.

The column address latch 125 may receive the column address COL_ADDR from the address register 121 and may temporarily store the received column address COL_ADDR. Additionally, the column address latch 125 may gradually increase the received column address COL_ADDR in a burst mode. The column address latch 125 may apply a temporarily stored or gradually increased column address COL_ADDR to each of the plurality of column decoders 127a to 127h.

Among the plurality of column decoders 127a to 127h, a column decoder activated by the bank control logic 122 may activate a sense amplifier corresponding to the bank address BANK_ADDR and the column address COL_ADDR through a corresponding input/output gating circuit 143.

The input/output gating circuit 143 may include, along with circuits for gating input/output data, an input data mask logic, read data latches for storing data output from the plurality of memory core circuits 141a to 141h, and write drivers for writing data to the plurality of memory core circuits 141a to 141h.

A data signal DQ to be read from one of the bank arrays of the plurality of memory core circuits 141a to 141h may be detected by the sense amplifier corresponding to the one bank array and may be stored in the read data latches. The data signal DQ stored in the read data latches may be provided to a memory controller along with a data strobe signal DQS.

A data signal DQ to be written to a memory cell array MCA included in one of the plurality of memory core circuits 141a to 141h may be provided to the input/output gating circuit 143 by the data input/output buffer 150. The input/output gating circuit 143 may write the data signal DQ to a target page of the one memory cell array MCA through the write drivers.

The data input/output buffer 150 may provide the data signal DQ to the input/output gating circuit 143 in a write operation, and may provide the data signal DQ provided from the input/output gating circuit 143 to the memory controller in a read operation.

The control logic circuit 110 may control an operation of the memory device 100. For example, the control logic circuit 110 may generate control signals so that the memory device 100 performs the write operation or the read operation. The control logic circuit 110 may include a command decoder 111 for decoding a command CMD received from the memory controller and a mode register 112 for setting an operation mode of the memory device 100.

For example, the command decoder 111 may decode a write enable signal, a row address strobe signal, a column address strobe signal, a chip select signal, and the like, to generate the control signals corresponding to the command CMD.

In order to reduce an area of the memory device 100, a memory cell array MCA and a circuit configured to control the memory cell array MCA may be stacked, such as a Cell-on-Peri (CoP) or Peri-on-Cell (PoC) structure. For example, when areas occupied by the memory cell array MCA and the core control circuit CCC may overlap each other in a direction, perpendicular to a substrate, the area of the memory device 100 may be reduced.

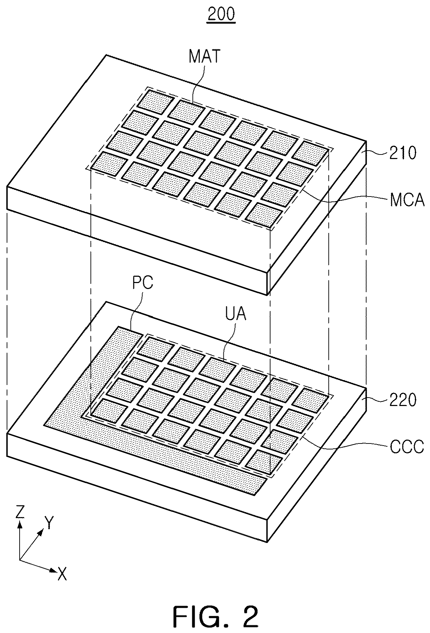

According to an example embodiment, the efficiency of interconnection lines between the memory cell array MCA and the core control circuit CCC may be improved to more effectively reduce the area of the memory device 100, and an interconnection structure that may also improve the driving capability of a wordline is proposed. Hereinafter, before the interconnection structure is described in detail, a structure of a memory device according to an example embodiment will be described with reference to FIGS. 2 to 4.

FIG. 2 is a perspective view simply illustrating a memory device according to an example embodiment.

Referring to FIG. 2, a memory device 200 may include a first semiconductor layer 210 and a second semiconductor layer 220. The first semiconductor layer 210 and the second semiconductor layer 220 may be stacked in a third direction (Z-direction), perpendicular to an upper surface of the substrate of the memory device 200.

The first semiconductor layer 210 may include the memory cell array MCA, and the second semiconductor layer 220 may include the core control circuit CCC. The memory cell array MCA and the core control circuit CCC of FIG. 2 may correspond to the memory cell array MCA and the core control circuit CCC described with reference to FIG. 1. The first semiconductor layer 210 may be referred to as a cell semiconductor layer, and the second semiconductor layer 220 may be referred to as a circuit semiconductor layer.

FIG. 2 exemplifies a case in which a memory device 200 includes one memory cell array MCA and one core control circuit CCC, but example embodiments are not limited thereto. For example, the memory device 200 may include a plurality of memory cell arrays MCA and a plurality of core control circuits CCC.

In an example embodiment, the memory device 200 may have a CoP structure in which a first semiconductor layer 210 is stacked on a second semiconductor layer 220.

The second semiconductor layer 220 may further include a peripheral circuit PC. For example, the peripheral circuit PC may include the control logic circuit 110, the address register 121, the bank control logic 122, the refresh counter 123, the row address multiplexer 124, the column address latch 125, the row decoder 126, the column decoder 127, the memory core circuit 141, the sense amplifier 142, the input/output gating circuit 143, and the data input/output buffer 150, as described with reference to FIG. 1.

FIG. 2 illustrates a case in which the peripheral circuit PC and the core control circuit CCC are included in the same semiconductor layer, but the peripheral circuit PC and the core control circuit CCC may be included in different semiconductor layers. For example, the memory device according to an example embodiment may have a three-layer structure in which the memory cell array MCA, the core control circuit CCC and the peripheral circuit PC are sequentially stacked.

The memory cell array MCA may include a plurality of sub-cell arrays. The plurality of sub-cell arrays may be arranged in a first direction (X-direction) and a second direction (Y-direction) that are parallel to the upper surface of the substrate of the memory device 200 and intersect each other. FIG. 2 illustrates a plurality of sub-cell regions MAT in which each of the sub-cell arrays is included.

Each of the plurality of sub-cell arrays may include a plurality of sub-wordlines extending in the first direction (X-direction), a plurality of bitlines extending in the second direction (Y-direction), and a plurality of memory cells connected to the plurality of sub-wordlines and the plurality of bitlines.

When the memory cell array MCA is divided into a plurality of sub-cell arrays, the number of memory cells connected to one sub-wordline is reduced, and a load for driving the wordline may be reduced.

The core control circuit CCC may include a plurality of unit control circuits configured to control the plurality of sub-cell arrays. FIG. 2 illustrates a plurality of unit areas UA in which each of the plurality of unit control circuits is included.

In an example embodiment, one unit area UA may overlap one sub-cell region MAT in the third direction (Z-direction) and may control one sub-cell array. For example, one unit area UA may include a sub-wordline driver circuit for driving wordlines included in the sub-cell array, a bitline sense amplifier circuit for detecting and amplifying signals of bitlines included in the sub-cell array, a row decoder circuit for generating control signals for the wordlines, and a power circuit for supplying power to circuits included in the unit control circuit.

However, example embodiments are not limited to one unit area UA overlapping one sub-cell region MAT, and one unit area UA may overlap a plurality of adjacent sub-cell regions MAT and may control the plurality of sub-cell arrays.

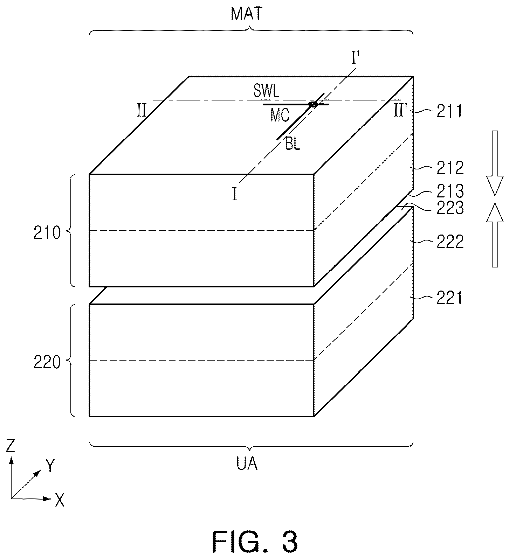

FIG. 3 is a perspective view illustrating a portion of a memory device described with reference to FIG. 2.

FIG. 3 illustrates a structure of one sub-cell region MAT, and one unit area UA overlapping the sub-cell region MAT in a third direction (Z-direction), in the memory device 200 described with reference to FIG. 2. The third direction (Z-direction) may be perpendicular to the first direction (X-direction) and second direction (Y-direction). The third direction (Z-direction) may be a direction in which the first semiconductor layer 210 and the second semiconductor layer 220 are stacked. The third direction (Z-direction) may be perpendicular to an upper surface of the substrate. The third direction (Z-direction) may define a vertical (or height) direction of the device. Various levels may be defined based on the third direction (Z-direction). The terms "upper", "middle", "lower", etc. may refer to relative positions along the third direction (Z-direction). It will be appreciated that these directions and relative positions defined herein do not necessarily imply any particular orientation of the device in use.

The first semiconductor layer 210 may include a cell structure layer 211 and a cell interconnection layer 212. The cell structure layer 211 may include a memory cell structure in the sub-cell region MAT. The memory cell structure may include a plurality of sub-wordlines SWL, a plurality of bitlines BL, and a plurality of memory cells MC connected to the plurality of sub-wordlines SWL and the plurality of bitlines BL. In an example embodiment, the plurality of sub-wordlines SWL may extend in the first direction (X-direction), and the plurality of bitlines BL may extend in the second direction (Y-direction).

The cell interconnection layer 212 may include cell interconnection lines for electrically connecting the plurality of sub-wordlines SWL and the plurality of bitlines BL to components of the second semiconductor layer 220. In an example embodiment, the cell interconnection lines may include metal elements such as tungsten (W).

The second semiconductor layer 220 may include a circuit element layer 221 and a circuit interconnection layer 222. The circuit element layer 221 may include semiconductor components included in a core control circuit for controlling the memory cell structure in the unit area UA.

The circuit interconnection layer 222 may include circuit interconnection lines for electrically connecting semiconductor components included in the core control circuit. In an example embodiment, the circuit interconnection lines may include metal elements such as tungsten (W).

For example, the core control circuit may include a sub-wordline driver circuit electrically connected to the plurality of sub-wordlines SWL and a bitline sense amplifier circuit electrically connected to the plurality of bitlines BL.

In an example embodiment, the first semiconductor layer 210 and the second semiconductor layer 220 may be bonded in a Cu-Cu bonding manner. For example, the cell interconnection layer 212 may include a first bonding surface 213 including first bonding pads, and the circuit interconnection layer 222 may include a second bonding surface 223 including second bonding pads. The bonding pads may include metal elements such as copper (Cu). The first bonding surface 213 and the second bonding surface 223 may be bonded, and the first bonding pads and the second bonding pads may be bonded, so that the interconnection lines of the cell interconnection layer 212 and the interconnection lines of the circuit interconnection layer 222 may be electrically connected.

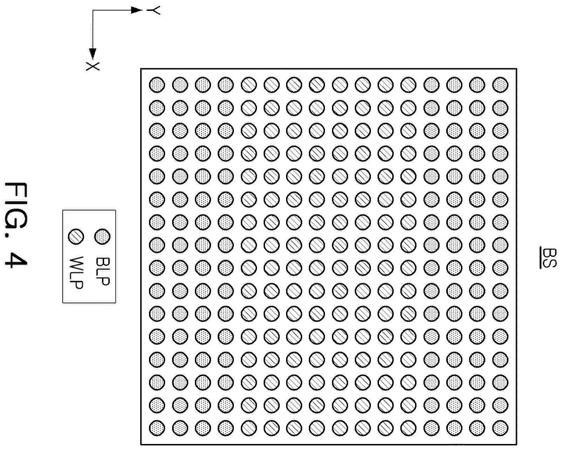

FIG. 4 is a view illustrating a bonding surface of a memory device according to an example embodiment.

FIG. 4 illustrates a bonding surface BS corresponding to one sub-cell region MAT or unit area UA of the memory device. The bonding surface BS may be formed by bonding the first bonding surface 213 and the second bonding surface 223 described with reference to FIG. 3.

The bonding surface BS may include a plurality of bonding pads. In the example of FIG. 4, the bonding surface BS may include bitline pads BLP and wordline pads WLP. The number of each of the bitline pads BLP and wordline pads WLP may be equal to the number of each of the bitlines BL and sub-wordlines SWL of the memory cell structure included in one sub-cell region MAT.

FIG. 4 illustrates a case in which bitline pads BLP are disposed on edges of the bonding surface BS with respect to the second direction (Y-direction), and wordline pads WLP are disposed in a center of the bonding surface BS. However, example embodiments are not limited thereto. For example, positions in which the bitline pads BLP and the wordline pads WLP are disposed may be determined according to the positions in which the bitline sense amplifier circuit and the sub-wordline driver circuit are disposed in the unit area UA.

According to what has been described with reference to FIGS. 3 and 4, the sub-cell region MAT, the unit area UA, and the bonding surface BS may overlap each other in the third direction (Z-direction). That is, because the memory cell structure and the core control circuit may overlap each other in the third direction (Z-direction), an area required for the memory device 200 may be reduced.

If the interconnection structure for electrically connecting the memory cell structure and the core control circuit also overlap the sub-cell region MAT and the unit area UA as much as possible, the area of the memory device 200 may be reduced more effectively. According to an example embodiment, an interconnection structure in which the driving capability for driving the sub-wordlines SWL may be improved while also increasing the area efficiency is proposed.

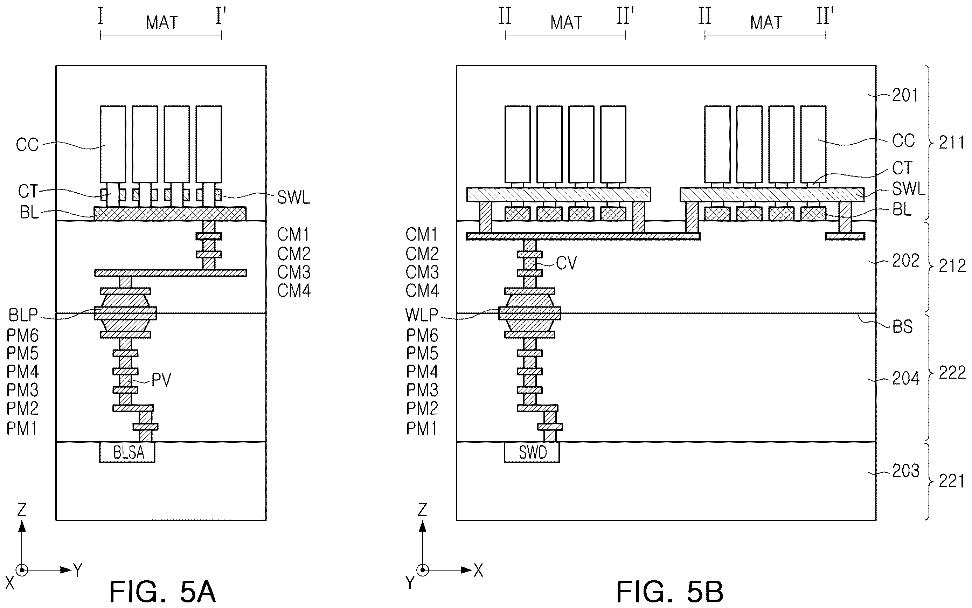

FIG. 5A is a cross-sectional view including line I-I' of FIG. 3, and FIG. 5B is a cross-sectional view including line II-II' of FIG. 3.

According to what has been described with reference to FIG. 3, the memory device 200 may include a first semiconductor layer 210 and a second semiconductor layer 220. FIG. 5A and FIG. 5B illustrate a cell structure layer 211 and a cell interconnection layer 212 included in a first semiconductor layer 210, and a circuit element layer 221 and a circuit interconnection layer 222 included in a second semiconductor layer 220.

Referring to FIG. 5A and FIG. 5B together, the cell structure layer 211 may include a memory cell structure including a plurality of cell capacitors CC, cell transistors CT, sub-wordlines SWL and bitlines BL, and an insulating layer 201 covering the memory cell structure. The plurality of cell capacitors CC may be arranged in a first direction (X-direction) and the second direction (Y-direction). The plurality of cell transistors CT may be arranged in the first direction (X-direction) and the second direction (Y-direction), and may be electrically connected to the plurality of cell capacitors CC. One cell capacitor CC and one cell transistor CT connected to each other may form one memory cell. In an example embodiment, the cell transistor CT may be a Vertical Channel Transistor (VCT) having a channel extending in the third direction (Z-direction). While the memory device 200 described herein includes cell transistors CT and cell capacitors CC (e.g., is a DRAM device), other forms of memory device may be implemented, including different forms of memory cell.

The bitlines BL may extend in a second direction (Y-direction) and be arranged in a first direction (X-direction). Each of the bitlines BL may be in contact in the third direction (Z-direction) with the cell transistors CT arranged in the second direction (Y-direction). The sub-wordlines SWL may extend in the first direction (X-direction) and may be arranged in the second direction (Y-direction). Each of the sub-wordlines SWL may be in contact in the second direction (Y-direction) with the cell transistors CT arranged in the first direction (X-direction).

The cell interconnection layer 212 may include a plurality of cell interconnection layers CM1 to CM4. Each of the plurality of cell interconnection layers CM1 to CM4 may include cell interconnection lines, and may include vias CV electrically connecting the cell interconnection lines between the cell interconnection layers CM1 to CM4. The cell interconnection layer 212 may include an insulating layer 202 covering the cell interconnection lines and the vias CV.

The interconnection structure formed by the cell interconnection lines and the vias CV may electrically connect each of the plurality of sub-wordlines SWL of the cell structure layer 211 to a wordline pad WLP, and may electrically connect each of the bitlines BL to a bitline pad BLP.

The circuit element layer 221 may include a substrate 203 and semiconductor components formed on one surface of the substrate 203. The semiconductor components may form a bitline sense amplifier BLSA and a sub-wordline driver SWD.

The circuit interconnection layer 222 may include a plurality of circuit interconnection layers PM1 to PM6. Each of the plurality of circuit interconnection layers PM1 to PM6 may include circuit interconnection lines, and may include vias PV electrically connecting the circuit interconnection lines between the circuit interconnection layers PM1 to PM6. The circuit interconnection layer 222 may include an insulating layer 204 covering (or surrounding) the circuit interconnection lines and the vias PV.

The interconnection structure formed by the circuit interconnection lines and the vias PV may electrically connect the bitline sense amplifier BLSA to the bitline pad BLP, and may electrically connect the sub-wordline driver SWD to the wordline pad WLP.

FIG. 5A and FIG. 5B illustrate four cell interconnection layers CM1 to CM4 and six circuit interconnection layers PM1 to PM6, but the number of cell interconnection layers and circuit interconnection layers is not limited thereto.

A first surface of the cell interconnection layer 212 may be in contact with the cell structure layer 211, and a second surface opposite to the first surface may be in contact with the circuit interconnection layer 222. A first surface of the circuit interconnection layer 222 may be in contact with the circuit element layer 221, and a second surface opposite to the first surface may be in contact with the cell interconnection layer 212. A bonding surface of a cell interconnection layer 212 and a circuit interconnection layer 222 may include a plurality of wordline pads WLP and a plurality of bitline pads BLP.

Referring to FIG. 5B, the sub-wordline driver SWD may overlap the memory cell structure, and at least a portion of the interconnection structure for electrically connecting the sub-wordline driver SWD and the sub-wordline SWL may overlap the memory cell structure. Depending on the interconnection structure, the integration of the memory device and the driving capability for the sub-wordlines SWL may be determined.

For example, one sub-wordline driver SWD may be shared by adjacent sub-wordlines SWL included in adjacent sub-cell regions MAT. For example, the sub-wordline driver SWD may be electrically connected to the adjacent wordlines SWL of the adjacent sub-cell regions MAT. By sharing the sub-wordline driver SWD with the adjacent sub-wordlines SWL, a core control circuit may be integrated within the unit area UA.

Additionally, the driving capability of the sub-wordline SWL may be improved by forming an electrical connection with the sub-wordline driver SWD in two or more positions of one sub-wordline SWL. For example, the cell interconnection layer 212 may include wordline interconnection lines that may electrically connect both ends of the sub-wordline SWL to the sub-wordline driver SWD.

For example, the wordline interconnection lines may be disposed in the first cell interconnection layer CM1. The wordline interconnection lines may be electrically connected to the sub-wordline driver SWD, may overlap the sub-wordlines SWL in the third direction (Z-direction), and may be electrically connected to both ends of the sub-wordlines SWL through contacts. Because the sub-wordlines SWL may be driven from both ends, the driving performance may be improved as compared to a case in which the sub-wordlines SWL are driven from one end.

However, as a pitch of the sub-wordlines SWL decreases, it may be difficult to efficiently dispose the wordline interconnection lines to overlap both ends of each of the sub-wordlines SWL. For example, the pitch of the sub-wordlines may be as small as one unit of a pitch of the interconnection lines of the cell interconnection layer 212. When the wordline interconnection lines are formed at one unit interval in one of the interconnection layers of the cell interconnection layer 212, the efficiency of the wiring connecting the bitlines BL to the bitline sense amplifier BLSA may be reduced.

Specifically, in order to connect the bitline BL to the bitline pad BLP, the interconnection lines of all the interconnection layers CM1 to CM4 should be connected between the bitline BL and the bitline pad BLP. When the wordline interconnection lines are disposed at one unit interval within the sub-cell region MAT in the first interconnection layer CM1, it may be difficult to dispose the bitline interconnection lines for connecting the bitlines BL to the bitline pad BLP within the sub-cell region MAT. In this case, an additional area may be required for disposing the bitline interconnection lines.

Additionally, when the wordline interconnection lines are disposed at one unit interval within the sub-cell region MAT, the coupling capacitance between the wordline interconnection lines may increase, and there may be a risk of causing short defects between the wordline interconnection lines.

According to an example embodiment, the wordline interconnection lines may be disposed similarly to a checkerboard pattern across a plurality of sub-cell regions. An arrangement structure of wordline interconnection lines according to an example embodiment may increase a pitch of wordline interconnection lines, and may simultaneously provide improved driving capability to the sub-wordlines SWL.

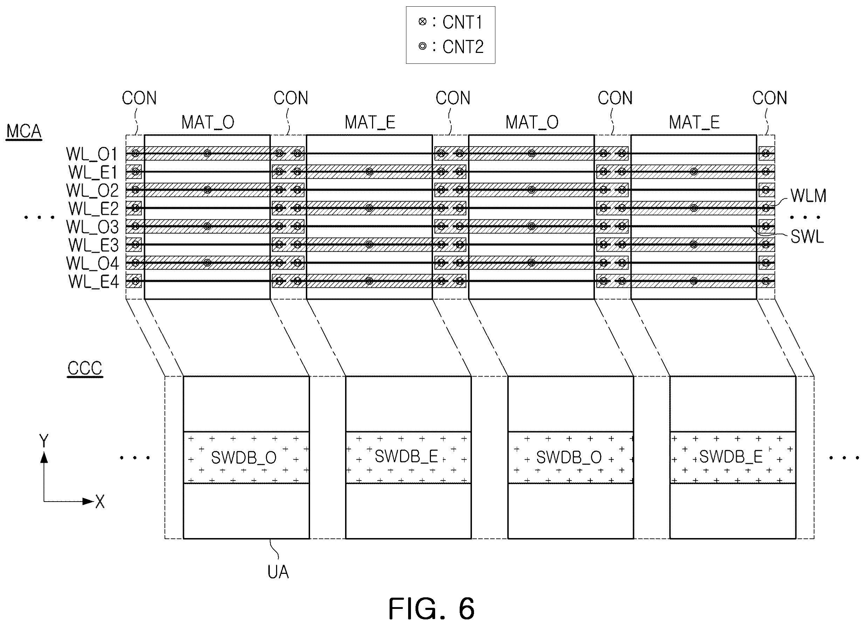

FIG. 6 is a view illustrating a structure of a memory cell array and a core control circuit of a memory device according to an example embodiment.

As described with reference to FIG. 2, an area of a memory cell array MCA may include a plurality of sub-cell regions MAT arranged in the first direction (X-direction) and the second direction (Y-direction). FIG. 6 illustrates a plurality of sub-cell regions (MAT: MAT_O, MAT_E) arranged in the first direction (X-direction), among the plurality of sub-cell regions. The plurality of sub-cell regions MAT may include first sub-cell regions and second sub-cell regions alternately disposed in the first direction (X-direction). The first sub-cell regions may be referred to as odd sub-cell regions MAT_O, and the second sub-cell regions may be referred to as even sub-cell regions MAT_E.

Contact regions CON may be disposed between the plurality of sub-cell regions MAT. That is, the contact regions CON may be disposed between odd sub-cell regions MAT_O and even sub-cell regions MAT_E adjacent to each other.

In the plurality of sub-cell regions MAT, the sub-wordlines SWL may be arranged in the first direction (X-direction) and the second direction (Y-direction). One sub-cell region MAT may include sub-wordlines SWL extending in the first direction (X-direction) and arranged in the second direction (Y-direction). The sub-wordlines SWL may extend to the contact regions CON on both sides of the sub-cell region MAT in the first direction (X-direction).

The sub-wordlines SWL disposed in one sub-cell region MAT may include first sub-wordlines and second sub-wordlines alternately disposed in the second direction (Y-direction). The first sub-wordlines may be referred to as odd sub-wordlines, and the second sub-wordlines may be referred to as even sub-wordlines. The odd sub-wordlines arranged in the first direction (X-direction) may form odd wordlines (WL_O: WL_O1-WL_O4), and the even sub-wordlines arranged in the first direction (X-direction) may form even wordlines (WL_E: WL_E1-WL_E4).

As described with reference to FIG. 5B, wordline interconnection lines for electrically connecting the sub-wordlines SWL to the sub-wordline driver SWD may be disposed in the cell interconnection layer. In the example of FIG. 6, wordline interconnection lines WLM may overlap the sub-wordlines SWL in the third direction (Z-direction).

According to an example embodiment, the wordline interconnection lines WLM may be disposed to alternately overlap the sub-wordlines arranged in the first direction (X-direction) and the sub-wordlines arranged in the second direction (Y-direction). That is, the wordline interconnection lines WLM may be disposed in a pattern similar to a checkerboard pattern in the plurality of sub-cell regions MAT.

The wordline interconnection lines WLM may include odd wordline interconnection lines overlapping the odd sub-wordlines WL_O of the odd sub-cell region MAT_O and even wordline interconnection lines overlapping the even sub-wordlines WL_E of the even sub-cell region MAT_E.

Each of the wordline interconnection lines WLM may overlap a sub-wordline SWL in the sub-cell region MAT, and may extend to contact regions CON on both sides of the sub-cell region MAT. Each of the wordline interconnection lines WLM may overlap sub-wordlines adjacent to the overlapping sub-wordline SWL in the first direction (X-direction), in the contact regions CON on both sides.

For example, each of the odd wordline interconnection lines may overlap an odd sub-wordline in the odd sub-cell region MAT_O, and additionally odd sub-wordlines in (e.g., of or from) adjacent even sub-cell regions MAT_E in the contact regions CON. For example, each of the odd wordline interconnection lines may overlap an odd sub-wordline in the odd sub-cell region MAT_O, and additionally may overlap in the contact regions CON odd sub-wordlines from adjacent even sub-cell regions MAT_E. Similarly, each of the even wordline interconnection lines may overlap an even sub-wordline in the even sub-cell region MAT_E, and additionally even sub-wordlines of adjacent odd sub-cell regions MAT_O in the contact regions CON. For example, each of the even wordline interconnection lines may overlap an even sub-wordline in the even sub-cell region MAT_E, and may additionally overlap in the contact regions CON even sub-wordlines from adjacent odd sub-cell regions MAT_O.

A region of the core control circuit CCC may include unit areas UA overlapping each of the plurality of sub-cell regions MAT in the third direction (Z-direction). Each of the unit areas UA may include a sub-wordline driver block (SWDB: SWDB_O, SWDB_E). The sub-wordline driver block SWDB may include sub-wordline drivers for driving each of the plurality of sub-wordlines.

The unit areas overlapping the odd sub-cell regions MAT_O may include an odd sub-wordline driver block SWDB_O for driving the odd sub-wordlines. Additionally, the unit areas overlapping the even sub-cell regions MAT_E may include an even sub-wordline driver block SWDB_E for driving even sub-wordlines.

The contact regions CON may include first contacts CNT1 for connecting the sub-wordlines SWL and the wordline interconnection lines WLM. The sub-cell regions MAT may include second contacts CNT2 for connecting the wordline interconnection lines WLM and the sub-wordline drivers.

According to an example embodiment, the wordline interconnection lines WLM in each of the sub-cell regions MAT may be disposed to alternately overlap the sub-wordlines SWL, thus increasing a gap of the wordline interconnection lines WLM. For example, when a pitch of the sub-wordlines SWL is one unit of a pitch of interconnection lines, a pitch of the wordline interconnection lines WLM may be two units. That is, the pitch of the wordline interconnection lines WLM may be twice the pitch of the sub-wordlines SWL.

According to an example embodiment, bitline interconnection lines for electrically connecting bitlines and bitline sense amplifiers may be disposed in a region between the wordline interconnection lines WLM. Accordingly, an additional region for disposing the bitline interconnection lines outside the sub-cell regions MAT may not be required, and the interconnection efficiency of the memory device may be improved. Additionally, the coupling capacitance between the wordline interconnection lines WLM may be reduced, and the risk of short circuit failure of the wordline interconnection lines WLM may be reduced.

Additionally, each of the wordline interconnection lines WLM may drive overlapping sub-wordlines on both sides in the sub-cell region, and may further drive sub-wordlines adjacent to the overlapping sub-wordlines. According to the interconnection structure of the wordline interconnection lines WLM, the sub-wordlines SWL may be driven in both ends, and the driving performance of the sub-wordlines SWL may be improved.

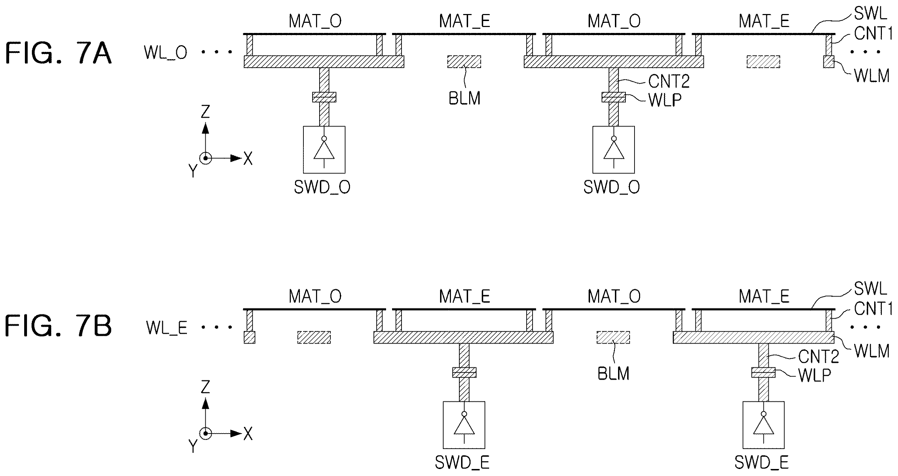

FIG. 7A and FIG. 7B are cross-sectional views of FIG. 6 taken along a wordline. FIG. 7A is a cross-sectional view of FIG. 6 taken along an odd wordline WL_O, and FIG. 7B is a cross-sectional view of FIG. 6 taken along an even wordline WL_E.

Referring to FIG. 7A, among the odd sub-wordlines forming the odd wordline WL_O, the sub-wordlines disposed in the odd sub-cell regions MAT_O and the wordline patterns WLM (e.g., the odd wordline interconnection lines) may overlap each other. The wordline patterns WLM (e.g., the odd wordline interconnection lines) may extend to the contact region CON and may overlap odd sub-wordlines of an adjacent even sub-cell region MAT_E. According to an embodiment, no odd wordline interconnection lines are positioned within (or extend into) the even sub-cell regions MAT_E. Nevertheless, the odd sub-wordlines of even sub-cell regions MAT_E are connected to the odd sub-wordline drivers SWD_O through connections in the contact regions CON to the adjacent odd wordline interconnection lines.

The wordline patterns WLM may be electrically connected to the overlapping odd sub-wordlines through the first contacts CNT1. The wordline patterns WLM disposed in the odd sub-cell region MAT_O may be electrically connected to an odd sub-wordline driver SWD_O overlapping the odd sub-cell region MAT_O through the second contacts CNT2 and the wordline pads WLP.

Each of the first contacts CNT1 and the second contacts CNT2 may include one via, but example embodiments are not limited thereto. For example, each of the first contacts CNT1 and the second contacts CNT2 may include a plurality of vias and an interconnection line formed in one or more interconnection layers.

According to an example embodiment, because the odd sub-wordlines disposed in the odd sub-cell region MAT_O may be electrically connected to the overlapping wordline pattern WLM in both ends, the odd sub-wordlines may be driven in both ends. Additionally, both ends of the odd sub-wordlines disposed in the even sub-cell region MAT_E may be electrically connected to wordline patterns WLM overlapping the adjacent odd sub-cell regions MAT_O. Even though the wordline patterns WLM for the odd sub-wordlines are not disposed in the even sub-cell region MAT_E, the odd sub-wordlines disposed in the even sub-cell region MAT_E may be driven in both ends. Accordingly, the driving performance of the sub-wordlines may be improved.

In a region in which wordline patterns WLM are not disposed, bitline patterns BLM for electrically connecting bitlines to bitline sense amplifiers may be disposed. Accordingly, interconnection efficiency may be improved.

Referring to FIG. 7B, among the even sub-wordlines included in the even wordline WL_E, sub-wordlines disposed in the even sub-cell region MAT_E and the wordline patterns WLM (e.g., the even wordline interconnection lines) may overlap each other. The wordline patterns WLM (e.g., the even wordline interconnection lines) may extend to the contact region CON and may overlap the even sub-wordlines of the adjacent odd sub-cell region MAT_O. According to an embodiment, no even wordline interconnection lines are positioned within (or extend into) the odd sub-cell regions MAT_O. Nevertheless, the even sub-wordlines of odd sub-cell regions MAT_O are connected to the even sub-wordline drivers SWD_E through connections in the contact regions CON to the adjacent even wordline interconnection lines.

The wordline patterns WLM may be electrically connected to the overlapping even sub-wordlines through the first contacts CNT1. The wordline patterns WLM disposed in the even sub-cell region MAT_E may be electrically connected to an even sub-wordline driver SWD_E overlapping the even sub-cell region MAT_E through the second contacts CNT2 and the wordline pads WLP.

Similarly to what has been described with reference to FIG. 7A, because each of the even sub-wordlines disposed in the odd sub-cell regions MAT_O and the even sub-cell regions MAT_E may be driven in both ends, the driving performance of the sub-wordlines may be improved. Additionally, because the bitline patterns BLM may be disposed in a region in which the wordline patterns WLM are not disposed, interconnection efficiency may be improved.

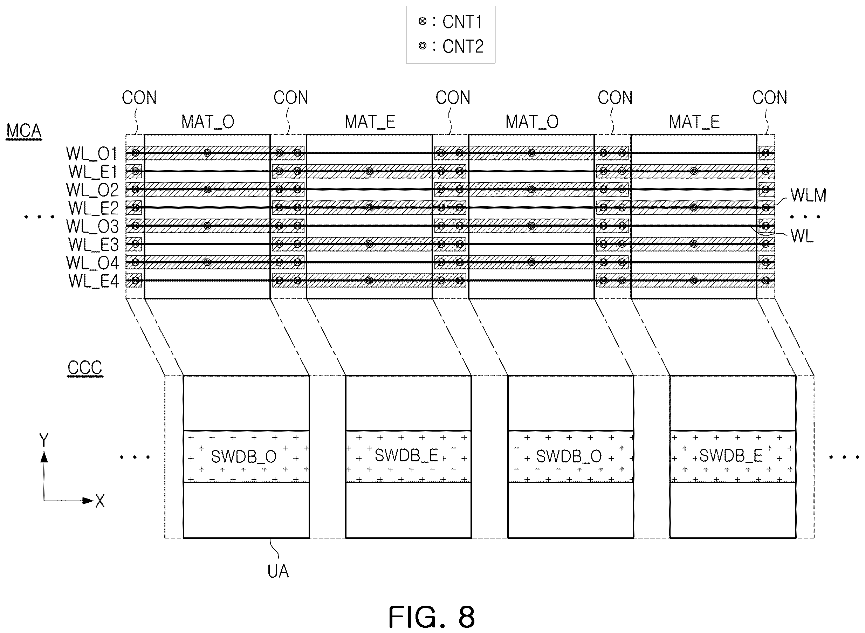

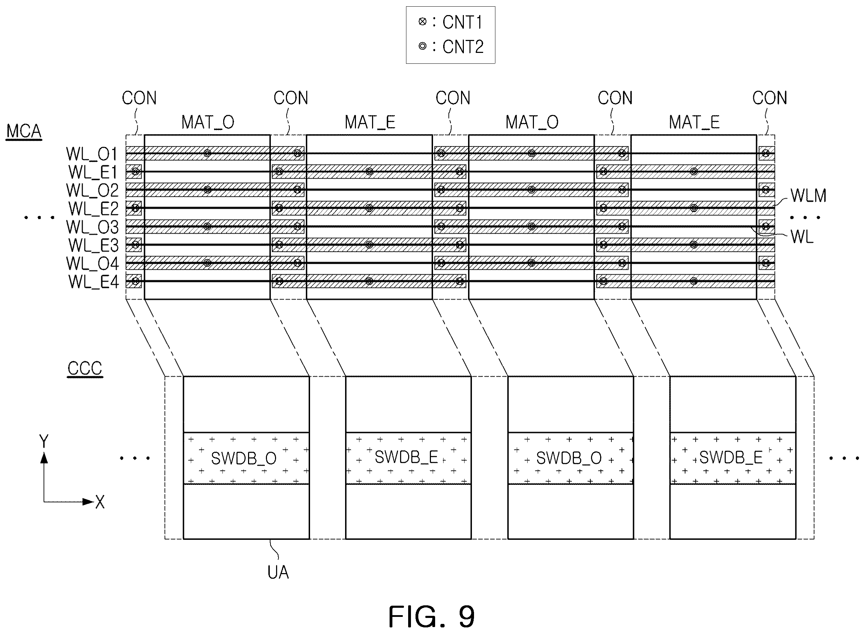

FIGS. 6, 7A and 7B illustrate a case in which each of wordlines WL_O and WL_E is separated into a plurality of sub-wordlines. However, example embodiments are not limited thereto. Hereinafter, a memory device according to example embodiments will be described with reference to FIGS. 8 and 9.

FIGS. 8 and 9 are views illustrating the structure of a memory cell region and a core control circuit of a memory device according to an example embodiment.

The memory device of FIG. 8 may have a structure similar to that of the memory device of FIG. 7. However, a plurality of sub-wordlines arranged in the first direction (X-direction) may not be separated from each other in the contact regions CON, but may extend across a plurality of sub-cell regions (MAT: MAT_O, MAT_E) to form one wordline WL.

The wordline WL may be electrically connected to a sub-wordline driver overlapping the sub-cell region MAT through the contact regions on both sides of the sub-cell region MAT, or to sub-wordline drivers overlapping adjacent sub-cell regions. Accordingly, even if one wordline WL extends across a plurality of sub-cell regions MAT, each of the connected sub-wordlines may be driven in both ends. Accordingly, this case may have the same driving performance as when the plurality of sub-wordlines are separated in the contact regions CON.

The memory device of FIG. 9 may have a structure similar to that of the memory device of FIG. 8. However, in each of the contact regions CON, one first contact CNT1 per wordline WL may be connected to the wordline interconnection line WLM. As in the case of FIG. 8, the wordline WL of FIG. 9 may also be electrically connected to the sub-wordline drivers through the contact regions on both sides of the sub-cell region MAT. Accordingly, this case may have improved driving performance, similarly to the memory device described with reference to FIGS. 6 and 8.

In the memory devices described with reference to FIGS. 6 to 9, among the circuits included in each of the unit areas UA, a sub-wordline driver block (SWDB: SWDB_0, SWDB_E) is simply illustrated. Each of the unit areas UA may include circuits such as the sub-wordline driver block SWDB as well as a bitline sense amplifier block BLSAB. The circuits in each of the unit areas UA may be disposed in various patterns.

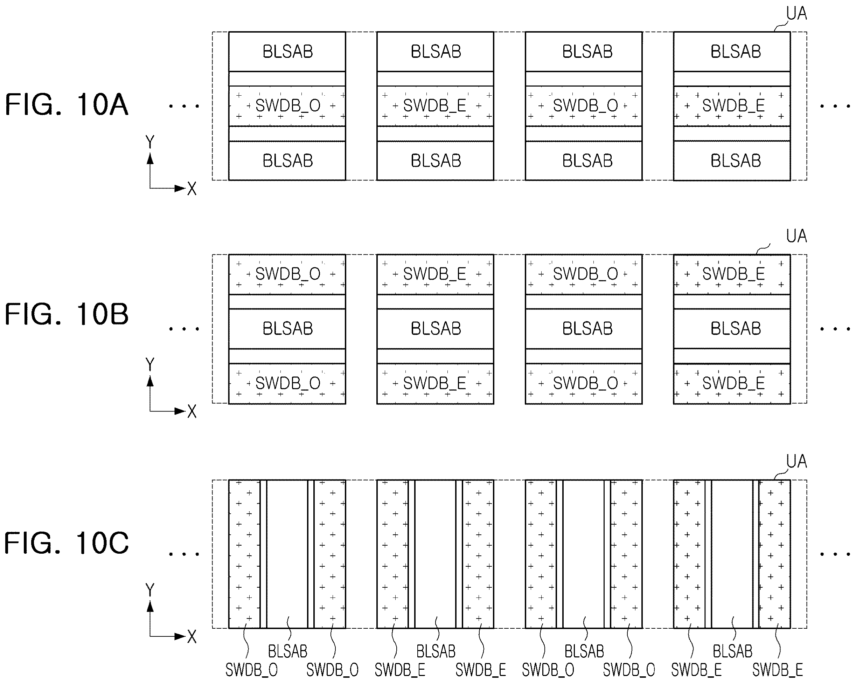

FIGS. 10A to 10C are views illustrating a structure of a core control circuit according to example embodiments.

FIG. 10A illustrates a case in which, as illustrated in FIGS. 6 to 9, sub-wordline driver blocks (SWDB: SWDB_O, SWDB_E) are disposed in a middle region of each unit area UA based on the second direction (Y-direction), and bitline sense amplifier blocks BLSAB are disposed in an edge region (e.g., in opposite edge regions in the second direction (Y-direction)). The sub-wordline driver blocks SWDB and bitline sense amplifier blocks BLSAB may extend in the first direction (X-direction) within the unit area UA. The bitline sense amplifier blocks BLSAB may include a plurality of bitline sense amplifiers connected to each of the bitlines included in the corresponding sub-cell region.

FIG. 10B illustrates a case in which the bitline sense amplifier block BLSAB is disposed in a middle region based on the second direction (Y-direction), and sub-wordline driver blocks SWDB are disposed in an edge region (e.g., in opposite edge regions in the second direction (Y-direction)). The sub-wordline driver blocks SWDB and the bitline sense amplifier block BLSAB may extend in the first direction (X-direction) within the unit area UA.

FIG. 10C illustrates a case in which the bitline sense amplifier block BLSAB is disposed in the middle region based on the first direction (X-direction) and the sub-wordline driver blocks SWDB are disposed in the edge region (e.g., in opposite edge regions in the first direction (X-direction)). The sub-wordline driver blocks SWDB and the bitline sense amplifier block BLSAB may extend in the second direction (Y-direction) within the unit area UA.

A pattern in which the sub-wordline driver block SWDB and the bitline sense amplifier block BLSAB are disposed is not limited to that illustrated in FIG. 10A to FIG. 10C. Depending on whether the sub-wordline driver block SWDB and the bitline sense amplifier block BLSAB extend in the first direction (X-direction) or the second direction (Y-direction), the interconnection efficiency of the wordline and the interconnection efficiency of the bitline may be determined.

In an example embodiment, the sub-wordline driver block SWDB and the bitline sense amplifier block BLSAB may be disposed in a windmill pattern. For example, the windmill pattern may be a pattern in which a unit area UA is divided into quadrants about a central point, and sub-wordline driver blocks SWDB and bitline sense amplifier blocks BLSAB are disposed in each quadrant in a rotational symmetry pattern. In a region in which the sub-wordline driver block SWDB and the bitline sense amplifier block BLSAB are not disposed in the unit area UA, a row decoder circuit, a power circuit, and the like, may be disposed.

In the case of edge sub-cell regions disposed on an edge among the sub-cell regions MAT arranged in the first direction (X-direction), an adjacent sub-cell region may be disposed on one side, but a sub-cell region may not be disposed on an opposite side. When the wordline interconnection line alternately overlaps the sub-wordlines in the edge sub-cell region, it may be difficult to connect the sub-wordline driver to both ends of the sub-wordlines in which the wordline interconnection line does not overlap.

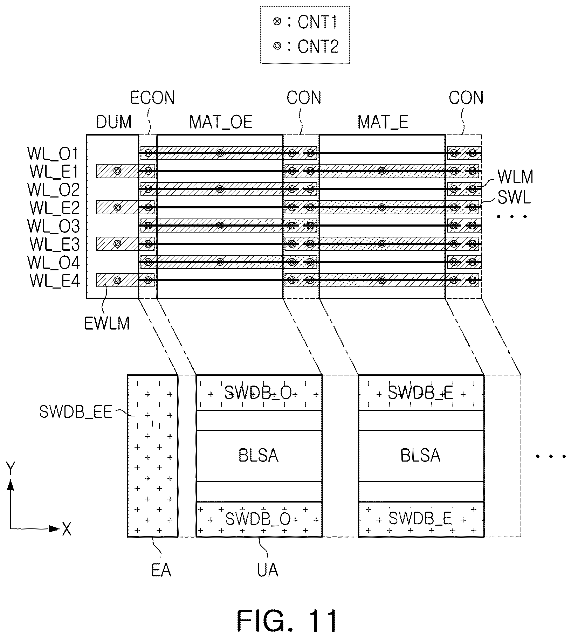

Hereinafter, examples of the structure of a memory device capable of providing the sub-wordlines on the edge with the same level of driving performance as the remaining sub-wordlines are described with reference to FIGS. 11 to 16C.

FIG. 11 is a view illustrating a structure of a memory cell array and a core control circuit of a memory device according to an example embodiment.

As described with reference to FIG. 6, the memory cell array MCA may include a plurality of sub-cell regions MAT arranged in the first direction (X-direction). FIG. 11 illustrates an edge odd sub-cell region MAT_OE disposed on an edge (e.g., at an end in the first direction (X-direction)), among the plurality of sub-cell regions MAT of the memory cell array MCA, and an even sub-cell region MAT_E adjacent to the edge odd sub-cell region MAT_OE.

A contact region CON may be disposed between the edge odd sub-cell region MAT_OE and an even sub-cell region MAT_E adjacent to the edge odd sub-cell region MAT_OE. Additionally, in the edge odd sub-cell region MAT_OE, an edge contact region ECON may be disposed in an opposite direction of (e.g., in an opposite direction to) the contact region CON. That is, the edge odd sub-cell region MAT_OE may be located between the edge contact region ECON and the contact region CON (e.g., in the first direction (X-direction)).

In the edge odd sub-cell region MAT_OE, the sub-wordlines SWL may include sub-wordlines SWL extending in the first direction (X-direction) and arranged in the second direction (Y-direction), intersecting the first direction (X-direction). The sub-wordlines SWL may extend to both sides based on the sub-cell region MAT.

The edge odd sub-cell region MAT_OE may include odd wordline interconnection lines overlapping the odd sub-wordlines. Additionally, the unit area UA overlapping the edge odd sub-cell region MAT_OE may include an odd sub-wordline driver block SWDB_O electrically connected to the odd wordline interconnection lines through second contacts CNT2.

According to an example embodiment, the memory cell array MCA may further include a dummy region DUM adjacent to the edge contact region ECON in the first direction (X-direction). Additionally, the core control circuit CCC may further include an edge region EA overlapping the dummy region DUM.

The edge region EA may include an edge sub-wordline driver block SWDB_EE for driving even sub-wordlines of the edge odd sub-cell region MAT_OE. The dummy region DUM may include edge wordline interconnection lines EWLM for electrically connecting the edge sub-wordline driver block SWDB_EE and the even sub-wordlines.

The edge wordline interconnection lines EWLM may extend from the dummy region DUM to the edge contact region ECON, and may be connected to the even sub-wordlines through the first contacts CNT1 in the edge contact region ECON. Additionally, the edge wordline interconnection lines EWLM may be connected to the edge sub-wordline driver block SWDB_EE through the second contacts CNT2 of the dummy region DUM.

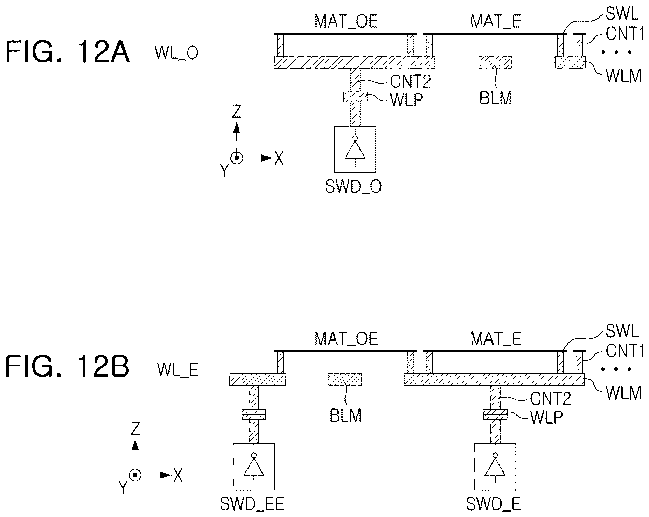

FIGS. 12A and 12B are cross-sectional views of FIG. 11 taken along the wordline. FIG. 12A is a cross-sectional view of FIG. 11 taken along an odd wordline WL_O, and FIG. 12B is a cross-sectional view of FIG. 11 taken along an even wordline WL_E.

Referring to FIG. 12A, the odd sub-wordlines overlapping the edge odd sub-cell region MAT_OE may be electrically connected to the odd wordline interconnection line through the first contacts CNT1 disposed in the contact region CON and the edge contact region ECON. Accordingly, the odd sub-wordlines overlapping the edge odd sub-cell region MAT_OE may be driven at both ends.

Referring to FIG. 12B, the even sub-wordline overlapping the edge odd sub-cell region MAT_OE may be connected to the even wordline interconnection line WLM overlapping an adjacent even sub-cell region MAT_E through the first contact CNT1 disposed in the contact region CON. The even wordline interconnection line WLM may be connected to the even sub-wordline driver SWD_E through the second contact CNT2 and the wordline pad WLP.

Additionally, the even sub-wordline may be connected to the edge wordline interconnection line EWLM through the first contact CNT1 disposed in the edge contact region ECON. The edge wordline interconnection line EWLM may be connected to an edge sub-wordline driver SWD_EE through the second contact CNT2 and the wordline pad WLP.

According to an example embodiment, even sub-wordlines disposed in the edge odd sub-cell region MAT_OE may be provided with the same level of driving performance as the remaining sub-wordlines. The memory cell array MCA may further include an edge even sub-cell region, and the same level of driving performance may be provided in the same manner to odd sub-wordlines disposed in the edge even sub-cell region. Depending on the number of sub-cell regions (e.g., arranged in one row in the first direction (X-direction), there may be two edge sub-cell regions, wherein each edge sub-cell region may be an edge odd sub-cell region or an edge even sub-cell region. For instance, the memory device may have two edge odd sub-cell regions arranged on opposite edges, two edge even sub-cell regions arranged on opposite edges, or an edge odd sub-cell region and an edge even sub-cell region arranged on opposite edges.

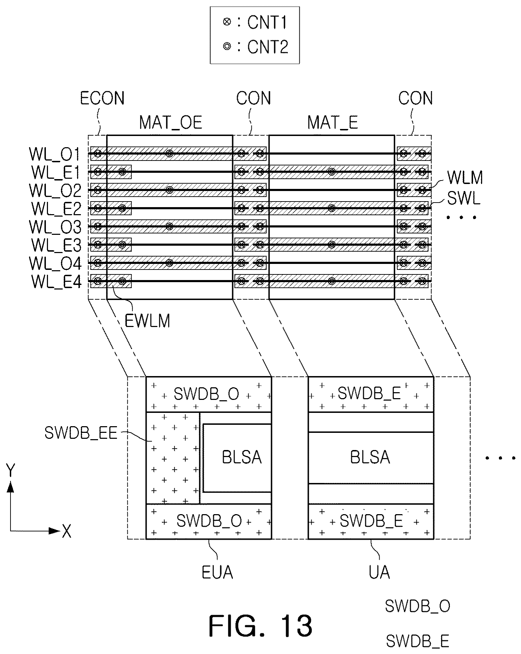

FIG. 13 is a view illustrating a structure of a memory cell array and a core control circuit of a memory device according to an example embodiment.

Referring to FIG. 13, an edge odd sub-cell region MAT_OE disposed on an edge, among a plurality of sub-cell regions MAT of the memory cell array MCA, and an even sub-cell region MAT_E adjacent to the edge odd sub-cell region MAT_OE are illustrated.

A contact region CON may be disposed between the edge odd sub-cell region MAT_OE and an even sub-cell region MAT_E adjacent to the edge odd sub-cell region MAT_OE. Additionally, an edge contact region ECON may be disposed in an opposite direction of (e.g., to) the contact region CON in the edge odd sub-cell region MAT_OE. The core control circuit CCC may include an edge unit area EUA overlapping the edge odd sub-cell region MAT_OE.

According to an example embodiment, the edge unit area EUA may further include an edge sub-wordline block SWDB_EE for driving even sub-wordlines, together with the odd sub-wordline block SWDB_O. The edge odd sub-cell region MAT_OE may further include edge wordline interconnection lines EWLM overlapping the even sub-wordlines and extending to the edge contact region ECON.

The edge wordline interconnection lines EWLM may be connected to the even sub-wordlines through the first contacts CNT1 in the edge contact region ECON. Additionally, the edge wordline interconnection lines EWLM may be connected to the edge sub-wordline driver block SWDB_EE through the second contacts CNT2 of the edge odd sub-cell region MAT_OE. The edge wordline interconnection lines EWLM may not extend completely across the edge odd sub-cell region MAT_OE. That is, a length of the edge wordline interconnection lines EWLM in the first direction (X-direction) may be shorter than the sum of lengths of the edge contact region ECON and the edge odd sub-cell region MAT_OE in the first direction (X-direction).

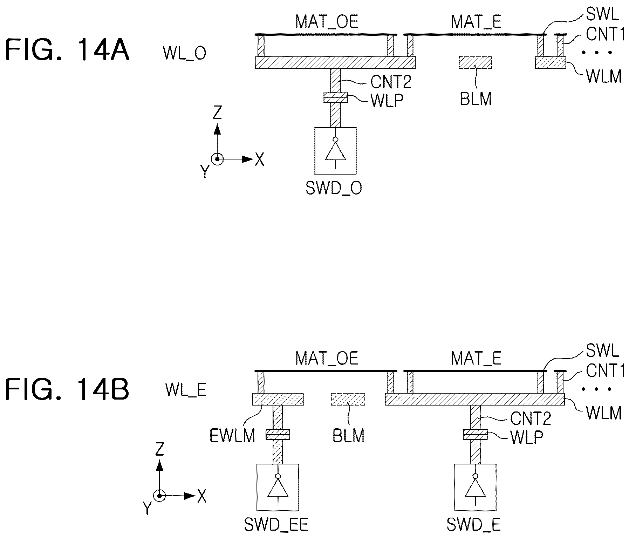

FIGS. 14A and 14B are cross-sectional views of FIG. 13 taken along the wordline. FIG. 14A is a cross-sectional view of FIG. 13 taken along the odd wordline WL_O, and FIG. 14B is a cross-sectional view of FIG. 13 taken along the even wordline WL_E.

Referring to FIG. 14A, as described with reference to FIG. 12A, odd sub-wordlines overlapping the edge odd sub-cell region MAT_OE may be driven in both ends.

Referring to FIG. 14B, the even sub-wordline overlapping the edge odd sub-cell region MAT_OE may be connected to the even sub-wordline driver SWD_E overlapping an adjacent even sub-cell region MAT_E through the first contact CNT1 disposed in the contact region CON.

Additionally, the even sub-wordline may be connected to the edge wordline interconnection line EWLM through the first contact CNT1 disposed in the edge contact region ECON. The edge wordline interconnection line EWLM may be connected to the edge sub-wordline driver SWD_EE through the second contact CNT2 and the wordline pad WLP.

According to an example embodiment, the same level of driving performance as the remaining sub-wordlines may be provided to even sub-wordlines disposed in the edge odd sub-cell region MAT_OE, and the same level of driving performance may be provided to odd sub-wordlines disposed in the edge even sub-cell region in the same manner.

Additionally, because the edge wordline interconnection line EWLM does not intersect (e.g., does not extend across the whole of) the edge odd sub-cell region MAT_OE, a bitline interconnection line BLM may be disposed in a region in which the wordline interconnection line of the edge odd sub-cell region MAT_OE is not disposed. Therefore, the wordline interconnection lines and the bitline interconnection line may be efficiently disposed.

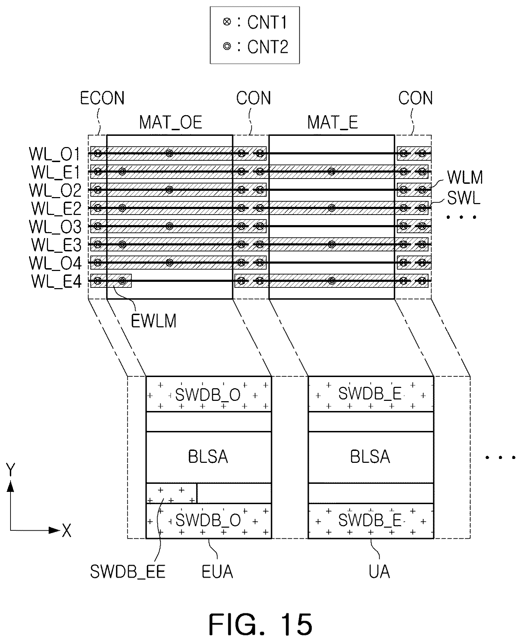

FIG. 15 is a view illustrating a structure of a memory cell array and a core control circuit of a memory device according to an example embodiment.

Referring to FIG. 15, an edge odd sub-cell region MAT_OE disposed on an edge, among a plurality of sub-cell regions MAT of a memory cell array MCA, and an even sub-cell region MAT_E adjacent to the edge odd sub-cell region MAT_OE are illustrated.

A contact region CON may be disposed between the even sub-cell region MAT_E adjacent to the edge odd sub-cell region MAT_OE. Additionally, an edge contact region ECON may be disposed in an opposite direction of (e.g., to) the contact region CON in the edge odd sub-cell region MAT_OE. The core control circuit CCC may include an edge unit area EUA overlapping the edge odd sub-cell region MAT_OE.

According to an example embodiment, the edge unit area EUA may further include an edge sub-wordline driver block SWDB_EE for driving even sub-wordlines, together with the odd sub-wordline driver block SWDB_O. In the example of FIG. 15, the edge sub-wordline driver block SWDB_EE may drive a fewer (e.g., smaller) number of sub-wordlines than the number of even sub-wordlines disposed in the edge odd sub-cell region MAT_OE, and may occupy a smaller area than that of the edge sub-wordline block SWDB_EE in the example of FIG. 13.

The edge sub-wordline block SWDB_EE may drive one or more even sub-wordlines, among the plurality of even sub-wordlines. For example, the edge sub-wordline driver block SWDB_EE may drive one or more even sub-wordlines forming a fourth even wordline WL_E4. For example, the edge sub-wordline driver block SWDB_EE may drive an even sub-wordline at an edge of the fourth even wordline WL_E4.

According to an example embodiment, the edge odd sub-cell region MAT_OE may further include wordline interconnection lines extending from even wordline interconnection lines of an adjacent even sub-cell region MAT_E to the edge contact region ECON and may overlap the remaining even sub-wordlines. The remaining even sub-wordlines may be connected to an even sub-wordline driver block SWDB_E overlapping an adjacent even sub-cell region MAT_E through the wordline interconnection lines.

A length of each of the edge wordline interconnection lines EWLM in the first direction (X-direction) may be shorter than the sum of lengths of the edge contact region ECON and the edge odd sub-cell region MAT_OE in the first direction (X-direction). Referring to FIG. 15, the edge odd sub-cell region MAT_OE may include a region in which a pitch of the wordline interconnection lines WLM is one unit of a pitch of the interconnection lines and a region in which the pitch is two units. According to an example embodiment, bitline interconnection lines may be disposed in a region between the wordline interconnection lines WLM in which the pitch is two units.

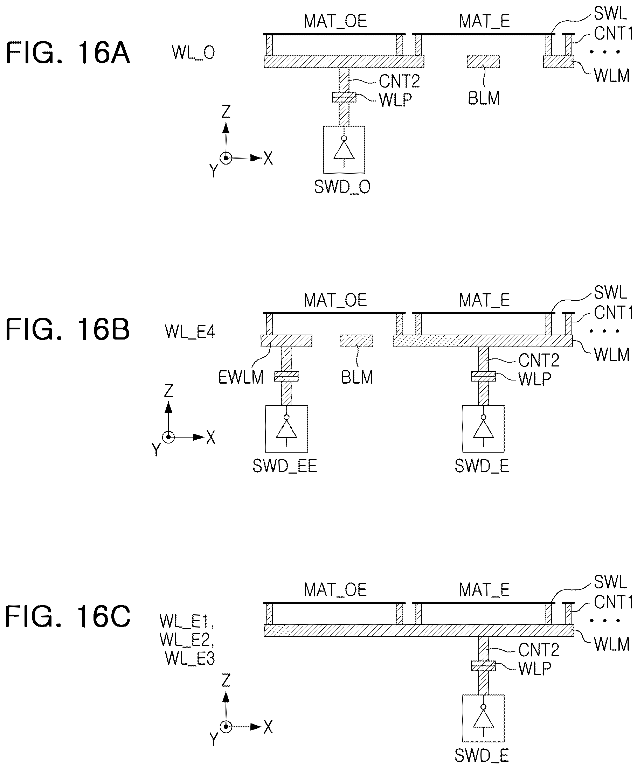

FIGS. 16A to 16C are cross-sectional views of FIG. 15 taken along a wordline. FIG. 16A is a cross-sectional view of FIG. 15 taken along an odd wordline WL_O, FIG. 16B is a cross-sectional view of FIG. 15 taken along an even wordline WL_E4, and FIG. 16C is a cross-sectional view of FIG. 15 taken along even wordlines WL_E1, WL_E2 and WL_E3.

Referring to FIG. 16A, similarly to the case of FIG. 14A, the odd sub-wordlines overlapping the edge odd sub-cell region MAT_OE may be driven at both ends.

Referring to FIG. 16B, similarly to the case of FIG. 14B, one or more of the even sub-wordlines overlapping the edge odd sub-cell region MAT_OE may be connected to an even sub-wordline driver SWD_E overlapping an adjacent even sub-cell region MAT_E through the first contact CNT1 disposed in the contact region CON. Additionally, the one or more of the even sub-wordlines overlapping the edge odd sub-cell region MAT_OE may be connected to an edge even sub-wordline driver SWD_EE through a first contact CNT1 in the edge contact region ECON and an edge wordline interconnection line EWLM. Additionally, the bitline interconnection line BLM may be disposed in a region in which the wordline interconnection line is not disposed. For instance, the bitline interconnection line BLM may be disposed in a region in in the edge odd sub-cell region MAT_OE in which the edge wordline interconnection line EWLM is not disposed.

Referring to FIG. 16C, some of the remaining even sub-wordlines overlapping the edge odd sub-cell region MAT_OE may be connected to the wordline interconnection lines WLM extending from an adjacent even sub-cell region MAT_E, and the even sub-wordline driver SWD_E overlapping an adjacent even sub-cell region MAT_E through the first contact CNT1 disposed in the contact region CON and the edge contact region ECON.

According to an example embodiment, the same level of driving performance as the remaining sub-wordlines may be provided to the even sub-wordlines disposed in the edge odd sub-cell region MAT_OE, and the same level of driving performance may be provided to the odd sub-wordlines disposed in the edge even sub-cell region in the same manner.

Additionally, because the bitline interconnection lines BLM may be disposed to overlap some of the even sub-wordlines, the efficiency of the interconnection line may be improved. In an interconnection layer in which the wordline interconnection line is disposed, the bitline interconnection lines BLM may occupy a local area like a contact. Accordingly, even if the wordline interconnection lines WLM do not overlap only some of the even sub-wordlines, like the even sub-wordlines forming the fourth even wordline WL_E4, the bitline interconnection lines BLM for all the bitlines disposed in the edge odd sub-cell region MAT_OE may be disposed.

The above embodiments discuss edge odd sub-cell regions but the teachings may be equally applied to one or more edge even sub-cell regions. In this case, edge odd wordline interconnection lines may be provided to connect to odd sub-word lines in the edge even sub-cell region.

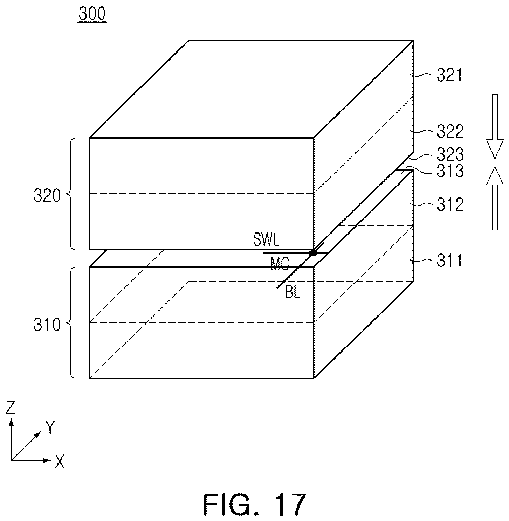

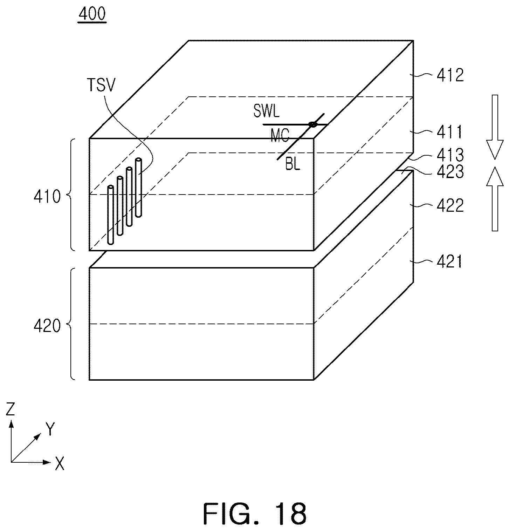

With reference to FIGS. 2 to 16C, example embodiments have been described in which the cell semiconductor layer is disposed on the circuit semiconductor layer, and the circuit interconnection layer of the circuit semiconductor layer and the cell interconnection layer of the cell semiconductor layer are bonded to each other. However, example embodiments are not limited thereto. Hereinafter, the structure of a memory device according to example embodiments is described with reference to FIGS. 17 and 18.

FIG. 17 and FIG. 18 are perspective views simply illustrating a memory device according to an example embodiment.

Referring to FIG. 17, a memory device 300 may include a first semiconductor layer 310 and a second semiconductor layer 320 stacked on the first semiconductor layer 310 in the third direction (Z-direction). The memory device 300 may have a PoC structure in which the circuit semiconductor layer is stacked on the cell semiconductor layer.

The first semiconductor layer 310 may include a cell structure layer 311 and a cell interconnection layer 312. The cell structure layer 311 and the cell interconnection layer 312 may have a structure similar to the cell structure layer 211 and the cell interconnection layer 212 described with reference to FIG. 3.

The second semiconductor layer 320 may include a circuit element layer 321 and a circuit interconnection layer 322. The circuit element layer 321 and the circuit interconnection layer 322 may have a structure similar to the circuit element layer 221 and the circuit interconnection layer 222 described with reference to FIG. 3.

In an example embodiment, the first semiconductor layer 310 and the second semiconductor layer 320 may be bonded by a Cu-Cu bonding method. A first bonding surface 313 of the cell interconnection layer 312 and a second bonding surface 323 of the circuit interconnection layer 322 may be bonded to each other, and first bonding pads formed on the first bonding surface 313 and second bonding pads formed on the second bonding surface 323 may be bonded to each other, so that the interconnection lines of the cell interconnection layer 312 and the interconnection lines of the circuit interconnection layer 322 may be electrically connected.

According to an example embodiment, the cell interconnection layer 312 may include wordline interconnection lines disposed to alternately overlap sub-wordlines arranged in the first direction (X-direction) and the second direction (Y-direction) across a plurality of sub-cell regions. Additionally, bitline interconnection lines may be disposed between the wordline interconnection lines.

Referring to FIG. 18, a memory device 400 may include a first semiconductor layer 410 and a second semiconductor layer 420. The first semiconductor layer 410 may be stacked on the second semiconductor layer 420 in the third direction (Z-direction). The first semiconductor layer 410 may include a cell structure layer 411 and a cell interconnection layer 412, and the second semiconductor layer 420 may include a circuit element layer 421 and a circuit interconnection layer 422.

In an example embodiment, a first bonding surface 413 of the cell structure layer 411 and a second bonding surface 423 of the circuit interconnection layer 422 may be bonded to each other, thereby bonding the first semiconductor layer 310 and the second semiconductor layer 320. Interconnection lines of the cell interconnection layer 412 may be electrically connected to interconnection lines of the circuit interconnection layer 422 through a Through-Silicon Via (TSV) connected to the cell interconnection layer 412 by penetrating through the cell structure layer 411.

According to an example embodiment, the cell interconnection layer 412 may include wordline interconnection lines disposed to alternately overlap sub-wordlines arranged in the first direction (X-direction) and the second direction (Y-direction) across the plurality of sub-cell regions. Additionally, bitline interconnection lines may be disposed between the wordline interconnection lines.

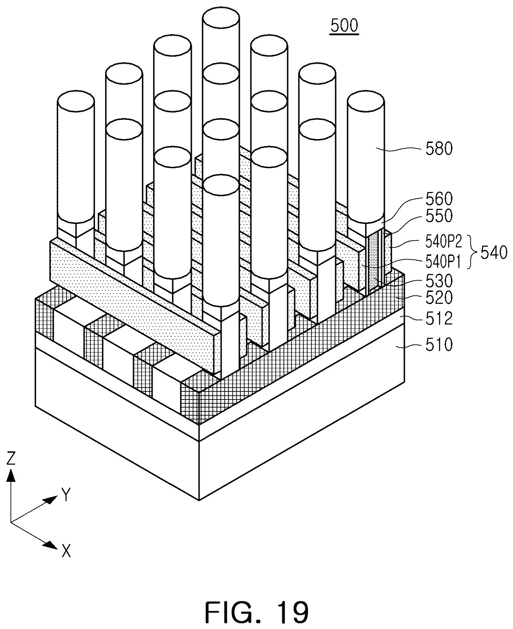

As described with reference to FIG. 5, the memory device may include a memory cell structure having a VCT as a cell transistor. An example of the structure of the memory cell structure is described with reference to FIG. 19.

FIG. 19 is a perspective view illustrating a memory cell structure of a memory device according to an example embodiment.

Referring to FIG. 19, an integrated circuit device 500 may include a substrate 510, a plurality of first conductive lines 520, a channel layer 530, a gate electrode 540, and a capacitor structure 580. The integrated circuit device 500 may be a memory device including a VCT. The vertical channel transistor may refer to a structure in which a channel length of the channel layer 530 extends in a vertical direction from the substrate 510.

A lower insulating layer 512 may be disposed on the substrate 510, and a plurality of first conductive lines 520 may be spaced apart from each other in the first direction (X-direction) on the lower insulating layer 512 and may extend in the second direction (Y-direction). The plurality of first conductive lines 520 may function as bitlines of the integrated circuit device 500.

In an example embodiment, the plurality of first conductive lines 520 may include doped polysilicon, a metal, a conductive metal nitride, a conductive metal silicide, a conductive metal oxide, or combinations thereof. The plurality of first conductive lines 520 may include a single layer or multiple layers of the aforementioned materials.

The channel layers 530 may be arranged in a matrix form in which the channel layers 530 are spaced apart from each other in the first direction (X-direction) and the second direction (Y-direction) on the plurality of first conductive lines 520. A bottom portion of the channel layer 530 may function as a first source/drain region, an upper portion of the channel layer 530 may function as a second source/drain region, and a portion of the channel layer 530 between the first and second source/drain regions may function as a channel region.

In an example embodiment, the channel layer 530 may include an oxide semiconductor. The channel layer 530 may be polycrystalline or amorphous, but example embodiments are not limited thereto. In an example embodiment, the channel layer 530 may include a two-dimensional semiconductor material, for example, the two-dimensional semiconductor material may include graphene, carbon nanotubes, or combinations thereof.

The gate electrode 540 may extend in the first direction (X direction) on both sidewalls of the channel layer 530. The gate electrode 540 may include a first sub-gate electrode 540P1 facing a first sidewall of the channel layer 530 and a second sub-gate electrode 540P2 facing a second sidewall opposite to the first sidewall of the channel layer 530. Because one channel layer 530 is disposed between the first sub-gate electrode 540P1 and the second sub-gate electrode 540P2, the integrated circuit device 500 may have a dualgate transistor structure. However, example embodiments are not limited thereto, and a single-gate transistor structure may be implemented by omitting the second sub-gate electrode 540P2 and forming only the first sub-gate electrode 540P1 facing the first sidewall of the channel layer 530.

The gate electrode 540 may include doped polysilicon, a metal, a conductive metal nitride, a conductive metal silicide, a conductive metal oxide, or combinations thereof.

A gate insulating layer 550 may surround a sidewall of the channel layer 530 and may be interposed between the channel layer 530 and the gate electrode 540. For example, as illustrated in FIG. 13, an entire sidewall of the channel layer 530 may be surrounded by the gate insulating layer 550, and a portion of a sidewall of the gate electrode 540 may be in contact with the gate insulating layer 550. In other example embodiments, the gate insulating layer 550 may extend in the first direction (X-direction) in which the gate electrode 540 extends, and only two sidewalls of the channel layer 530 facing the gate electrode 540 may be in contact with the gate insulating layer 550.

In an example embodiment, the gate insulating layer 550 may be formed of a silicon oxide film, a silicon oxynitride film, a high-k dielectric film having a higher dielectric constant than the silicon oxide film, or combinations thereof. The high-k dielectric film may be formed of a metal oxide or a metal oxynitride.

A capacitor contact 560 may be disposed on the channel layer 530. The capacitor contact 560 may be disposed to vertically overlap the channel layer 530, and the capacitor contacts 560 may be arranged in a matrix form in which the capacitor contacts 560 are spaced apart from each other in the first direction (X-direction) and the second direction (Y-direction).

The capacitor structure 580 may be included on the capacitor contact 560. The capacitor structure 580 may include a lower electrode, an upper electrode, and a dielectric layer between the lower electrode and the upper electrode.

The lower electrode may be electrically connected to an upper surface of the capacitor contact 560. The lower electrode may be formed as a pillar type extending in the third direction (Z-direction), but example embodiments are not limited thereto. In an example embodiment, the lower electrode may be vertically disposed to overlap a capacitor contact 560, and the lower electrodes may be arranged in a matrix form in which the lower electrodes are spaced apart from each other in the first direction (X-direction) and the second direction (Y-direction). Alternatively, a landing pad may be further disposed between the capacitor contact 260 and the lower electrode, so that the lower electrodes may be arranged in a hexagonal shape.

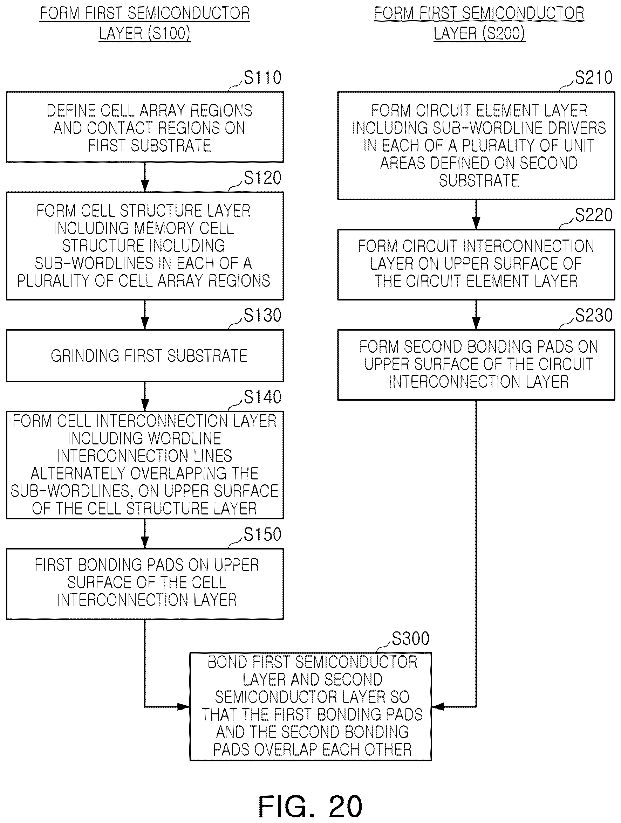

FIG. 20 is a flow chart illustrating a manufacturing method of a memory device according to an example embodiment.

Referring to FIG. 20, the manufacturing method of a memory device may include an operation of forming a first semiconductor layer (S100), an operation of forming a second semiconductor layer (S200), and an operation of bonding the first semiconductor layer and the second semiconductor layer (S300). In an example embodiment, operations S100 and S200 may be performed in parallel.

Operation S100 may include operations S110 to S150.

In operation S110, a plurality of cell array regions and contact regions may be defined on a first substrate. For example, the plurality of cell array regions may be arranged in a first direction and a second direction, parallel to an upper surface of the first substrate. Contact regions may be defined between the plurality of cell array regions arranged in the first direction.

In operation S120, memory cell structures including sub-wordlines may be formed in each of the plurality of cell array regions. A cell structure layer may be formed by covering the memory cell structures with an insulating layer.

In operation S130, the cell structure layer may be reversed, and the first substrate on the cell structure layer may be removed by grinding.

In operation S140, on an upper surface of the cell structure layer, a cell interconnection layer including wordline interconnection lines alternately overlapping the sub-wordlines may be formed.

For example, a plurality of sub-cell regions arranged in the first direction may include sub-wordlines arranged in the first direction and the second direction. The wordline interconnection lines may be disposed to alternately overlap the sub-wordlines arranged in the first direction and the second direction. Each of the wordline interconnection lines may extend to adjacent contact regions. Each of the wordline interconnection lines may overlap one sub-wordline in the sub-cell region, and may overlap sub-wordlines adjacent to the sub-wordline and the adjacent contact regions.

In operation S150, first bonding pads may be formed on an upper surface of the cell interconnection layer. For example, the first bonding pads may include wordline pads electrically connected to the sub-wordlines and bitline pads electrically connected to the bitlines.

Operation S200 may include operations S210 to S230.

In operation S210, a circuit element layer may be formed by forming circuit elements in each of a plurality of unit areas defined on a second substrate. For example, the circuit elements may include elements of a core control circuit including sub-wordline drivers and bitline sense amplifiers.

In operation S220, a circuit interconnection layer may be formed by forming circuit interconnection lines on an upper surface of the circuit element layer and covering the circuit interconnection lines with an insulating layer. The circuit interconnection lines may electrically connect the circuit elements to provide the core control circuit.

In operation S230, second bonding pads may be formed on an upper surface of the circuit interconnection layer. For example, the second bonding pads may include wordline pads electrically connected to sub-wordline drivers and bitline pads electrically connected to bitline sense amplifiers.

In operation S300, the first semiconductor layer and the second semiconductor layer may be bonded so that the first bonding pads and the second bonding pads overlap each other. By bonding the first semiconductor layer and the second semiconductor layer, a plurality of unit areas and a plurality of sub-cell regions may also overlap each other, and the sub-wordline drivers and the sub-wordlines may be electrically connected to each other, and the bitline sense amplifiers and the bitlines may be electrically connected to each other.

According to an example embodiment, because the wordline interconnection lines are disposed to alternately overlap the sub-wordlines in the sub-cell regions, even as a pitch of the sub-wordlines decreases, a sufficient gap for disposing the bitline interconnection lines may be secured between the wordline interconnection lines. Accordingly, the efficiency of interconnection lines in the sub-cell regions may be improved.

Additionally, because the alternately disposed wordline interconnection lines may also be electrically connected to adjacent sub-wordlines, each of the sub-wordlines may be electrically connected to the sub-wordline driver in both ends. Because the sub-wordlines may be driven in both ends, the driving performance may be improved.

The present description refers to "odd" and "even" elements of a plurality of elements. This may refer to first and second sets of elements, wherein the first and second sets alternate. The terms "odd" and "even" may refer to the number of the element in the series (e.g., an odd number of an even number). The terms "odd" and "even" may be replaced with the terms "first" and "second".

The term "overlap" (or "overlapping", or like terms), as may be used herein, is intended to broadly refer to a first element that intersects with at least a portion of a second element in a vertical direction (i.e., in the third direction (Z-direction)), but does not require that the first and second elements be completely aligned with one another in a horizontal plane (i.e., in the first direction (X-direction) and/or second direction (Y-direction). That is, components or layers described with reference to "overlap" in a particular direction may be at least partially obstructed by one another when viewed along a line extending in the particular direction.

Embodiments are set out in the following Clauses:
Clause 1. A memory device, comprising:
   a cell semiconductor layer respectively comprising a plurality of sub-cell regions arranged in a first direction, and a plurality of contact regions between the plurality of sub-cell regions, wherein the plurality of sub-cell regions comprise a plurality of memory cells; and
   a circuit semiconductor layer on the cell semiconductor layer and comprising a circuit configured to control the plurality of memory cells,
   wherein the cell semiconductor layer comprises:
      sub-wordlines extending in the first direction from the plurality of sub-cell regions to adjacent contact regions, wherein the sub-wordlines are spaced apart along a second direction intersecting the first direction; and
      wordline interconnection lines, and
   wherein the wordline interconnection lines comprise:
      odd wordline interconnection lines extending from an odd sub-cell region, among the plurality of sub-cell regions, to the adjacent contact regions, the odd wordline interconnection lines overlapping, in a third direction, odd sub-wordlines in the odd sub-cell region and even sub-wordlines in even sub-cell regions adjacent to the odd sub-cell region in the first direction, wherein the third direction intersects the first direction and the second direction; and
      even wordline interconnection lines extending from an even sub-cell region, among the plurality of sub-cell regions, to the adjacent contact regions, the even wordline interconnection lines overlapping, in the third direction, even sub-wordlines in the even sub-cell region and odd sub-wordlines in odd sub-cell regions adjacent to the even sub-cell region in the first direction.
Clause 2. The memory device of Clause 1, wherein the cell semiconductor layer comprises contacts connecting the odd wordline interconnection lines to the overlapping odd sub-wordlines, and contacts connecting the even wordline interconnection lines to the overlapping even sub-wordlines in the plurality of contact regions.
Clause 3. The memory device of Clause 1 or Clause 2, wherein the circuit semiconductor layer comprises a plurality of unit areas overlapping the plurality of sub-cell regions in the third direction, and
   wherein each of the plurality of unit areas comprises a plurality of sub-wordline drivers.
Clause 4. The memory device of Clause 3, wherein the plurality of sub-wordline drivers are connected to a wordline interconnection line overlapping corresponding sub-cell regions.
Clause 5. The memory device of Clause 3 or Clause 4, wherein the cell semiconductor layer comprises:
   a cell structure layer comprising the plurality of memory cells and the sub-wordlines; and
   a cell interconnection layer comprising a first interconnection layer on which the wordline interconnection lines are provided, and
   wherein the circuit semiconductor layer comprises:
   a circuit element layer comprising semiconductor components of the plurality of sub-wordline drivers; and
   a circuit interconnection layer comprising interconnection lines electrically connecting the semiconductor components.
Clause 6. The memory device of any of Clauses 3-5, wherein each of the plurality of unit areas further comprises a plurality of bitline sense amplifiers, and
   wherein the plurality of bitline sense amplifiers are connected to bitlines connected to the plurality of memory cells through bitline interconnection lines formed in an interconnection layer on a same level as the wordline interconnection lines.
Clause 7. The memory device of any preceding Clause, wherein the cell semiconductor layer further comprises:
   a dummy region spaced apart from an edge odd sub-cell region, among the plurality of sub-cell regions, in the first direction;
   an edge contact region between the edge odd sub-cell region and the dummy region; and
   edge wordline interconnection lines overlapping the dummy region and the edge contact region, and connected to even sub-wordlines of the edge odd sub-cell region, in the edge contact region,

   wherein the circuit semiconductor layer further comprises an edge circuit region overlapping the edge odd sub-cell region in the third direction and comprising edge sub-wordline drivers, and
   wherein the edge sub-wordline drivers are connected to the edge wordline interconnection lines.
Clause 8. The memory device of any of Clauses 1-6, wherein the cell semiconductor layer further comprises an edge contact region which is adjacent to an edge odd sub-cell region, among the plurality of sub-cell regions, in the first direction, and which is provided in an opposite direction of an adjacent contact region among the plurality of contact regions,
   wherein the edge odd sub-cell region further comprises edge wordline interconnection lines connected to even sub-wordlines of the edge odd sub-cell region, and
   wherein the circuit semiconductor layer further comprises edge sub-wordline drivers overlapping the edge odd sub-cell region in the third direction and connected to the edge wordline interconnection lines.
Clause 9. The memory device of Clause 8, wherein in the first direction, a length of the edge wordline interconnection lines is shorter than a sum of a length of the edge contact region and a length of the edge odd sub-cell region.
Clause 10. The memory device of any of Clauses 1-6, wherein the cell semiconductor layer further comprises an edge contact region which is adjacent to an edge odd sub-cell region, among the plurality of sub-cell regions, in the first direction, and which is provided in an opposite direction of an adjacent contact region among the plurality of contact regions,
   wherein the edge odd sub-cell region comprises:
      a first edge wordline interconnection line extending from a first even wordline interconnection line of an adjacent even sub-cell region to the edge contact region, wherein the first edge wordline interconnection line is connected to a first even sub-wordline of the edge odd sub-cell region; and
      a second edge wordline interconnection line spaced apart from a second wordline interconnection line of the adjacent even sub-cell region, wherein the second edge wordline interconnection line is connected to a second even sub-wordline of the edge odd sub-cell region in the adjacent contact region, and
   wherein the circuit semiconductor layer further comprises an edge sub-wordline driver overlapping the edge odd sub-cell region in the third direction, and connected to the second edge wordline interconnection line.
Clause 11. The memory device of Clause 10, wherein in the first direction, a length of the second edge wordline interconnection line is shorter than a sum of a length of the edge contact region and a length of the edge odd sub-cell region.
Clause 12. The memory device of Clause 10 or Clause 11, wherein the circuit semiconductor layer comprises a plurality of edge sub-wordline drivers, the plurality of edge sub-wordline drivers comprising the edge sub-wordline driver, and
   wherein a number of the plurality of edge sub-wordline drivers is less than a number of even sub-wordlines in the edge odd sub-cell region.
Clause 13. The memory device of any preceding Clause, wherein the sub-wordlines aligned in the first direction in the plurality of sub-cell regions are connected to each other.
Clause 14. The memory device of any preceding Clause, wherein the memory device has a Cell on Periphery (CoP) structure in which the cell semiconductor layer is on the circuit semiconductor layer.
Clause 15. The memory device of any preceding Clause, wherein the memory device has a Cell on Periphery (CoP) structure in which the cell semiconductor layer is on the circuit semiconductor layer.
Clause 16. A memory device, comprising:
   a plurality of sub-cell regions respectively comprising a plurality of memory cells and arranged in a first direction;
   a plurality of contact regions between the plurality of sub-cell regions;
   a plurality of sub-wordlines extending in the first direction from the plurality of sub-cell regions to adjacent contact regions, wherein the plurality of sub-wordlines are spaced apart along a second direction intersecting the first direction; and
   a plurality of wordline interconnection lines that alternately overlap adjacent sub-cell regions among the plurality of sub-cell regions, wherein the plurality of wordline interconnection lines extend in the first direction from at least some of the plurality of sub-cell regions to the adjacent contact regions and overlap sub-wordlines adjacent to overlapping sub-wordlines in the first direction, in the adjacent contact regions,
   wherein at least some of the plurality of wordline interconnection lines are connected to the overlapping sub-wordlines in the adjacent contact regions, and the plurality of wordline interconnection lines are connected to sub-wordline drivers that overlap at least some of the plurality of sub-cell regions.
Clause 17. The memory device of Clause 16, further comprising:
   a plurality of bitlines extending in the second direction in at least some of the plurality of sub-cell regions, wherein the plurality of bitlines are spaced apart in the first direction;
   bitline sense amplifiers in each of the plurality of sub-cell regions; and
   an interconnection structure connecting the plurality of bitlines and the bitline sense amplifiers,
   wherein the interconnection structure comprises bitline interconnection lines on a same level as the plurality of wordline interconnection lines between the plurality of wordline interconnection lines.
Clause 18. The memory device of Clause 17, wherein each of the plurality of memory cells comprises a cell capacitor and a cell transistor in contact with the cell capacitor in a third direction, perpendicular to the first and second directions, and
   wherein the cell transistor is contact with the plurality of bitlines aligned in the third direction, and is in contact with the plurality of sub-wordlines aligned in the second direction.
Clause 19. A manufacturing method of a memory device, comprising:
   forming a cell structure layer comprising a memory cell structure having sub-wordlines extending in a first direction in a plurality of sub-cell regions defined on a first substrate, wherein the sub-wordlines are spaced apart in a second direction, intersecting the first direction;
   inverting the cell structure layer and grinding the first substrate;
   forming a cell interconnection layer comprising wordline interconnection lines alternately overlapping sub-wordlines in the first direction and the second direction in the plurality of sub-cell regions, the wordline interconnection lines extending to adjacent contact regions to overlap adjacent sub-wordlines, on an upper surface of the cell structure layer;
   forming a circuit element layer by forming sub-wordline drivers in a plurality of unit areas defined on a second substrate;
   forming a circuit interconnection layer on an upper surface of the circuit element layer; and
   bonding the cell interconnection layer and the circuit interconnection layer so that the plurality of sub-cell regions and the plurality of unit areas overlap each other.
Clause 20. The manufacturing method of a memory device of Clause 19, further comprising:
   forming first bonding pads on a surface of the cell interconnection layer; and
   forming second bonding pads on a surface of the circuit interconnection layer, wherein the bonding the cell interconnection layer and the circuit interconnection layer comprises bonding the first bonding pads and the second bonding pads.

While aspects of example embodiments have been particularly shown and described, it will be understood that various changes in form and details may be made therein without departing from the scope of the following claims.

## Claims

1. A memory device, comprising:
a cell semiconductor layer (210) respectively comprising a plurality of sub-cell regions (MAT) arranged in a first direction, and a plurality of contact regions (CON) between the plurality of sub-cell regions (MAT), wherein the plurality of sub-cell regions (MAT) comprise a plurality of memory cells (MC); and
a circuit semiconductor layer (220) stacked with the cell semiconductor layer (210) and comprising a circuit configured to control the plurality of memory cells (MC),
wherein the cell semiconductor layer (210) comprises:
sub-wordlines (SWL) extending in the first direction from the plurality of sub-cell regions (MAT) to adjacent contact regions (CON), wherein the sub-wordlines (SWL) are spaced apart along a second direction intersecting the first direction; and
wordline interconnection lines (WLM), and
wherein the wordline interconnection lines (WLM) comprise:
odd wordline interconnection lines (WLM_O) extending from an odd sub-cell region (MAT_O), among the plurality of sub-cell regions (MAT), to the adjacent contact regions (CON), the odd wordline interconnection lines (WLM_O) overlapping, in a third direction, odd sub-wordlines (WL_O) in the odd sub-cell region (MAT_O) and odd sub-wordlines (WL_O) in even sub-cell regions adjacent (MAT_E) to the odd sub-cell region (MAT_O) in the first direction, wherein the third direction intersects the first direction and the second direction; and
even wordline interconnection lines (WLM_E) extending from an even sub-cell region (MAT_E), among the plurality of sub-cell regions (MAT), to the adjacent contact regions (CON), the even wordline interconnection lines (WLM_E) overlapping, in the third direction, even sub-wordlines (WL_E) in the even sub-cell region (MAT_E) and even sub-wordlines (WL_E) in odd sub-cell regions (MAT_O) adjacent to the even sub-cell region (MAT_E) in the first direction.

2. The memory device of claim 1, wherein the cell semiconductor layer (210) comprises contacts connecting the odd wordline interconnection lines (WLM_O) to the overlapping odd sub-wordlines (WL_O), and contacts connecting the even wordline interconnection lines (WLM_E) to the overlapping even sub-wordlines (WL_E) in the plurality of contact regions (CON).

3. The memory device of claim 1 or claim 2, wherein the circuit semiconductor layer (220) comprises a plurality of unit areas (UA) overlapping the plurality of sub-cell regions (MAT) in the third direction, and
wherein each of the plurality of unit areas comprises (UA) a plurality of sub-wordline drivers (SWD).

4. The memory device of claim 3, wherein each of the plurality of sub-wordline drivers (SWD) is connected to a corresponding wordline interconnection line (WLM) overlapping a corresponding sub-cell region (MAT).

5. The memory device of claim 3 or claim 4, wherein the cell semiconductor layer (210) comprises:
a cell structure layer (211) comprising the plurality of memory cells (MC) and the sub-wordlines (WL); and
a cell interconnection layer (212) comprising a first interconnection layer (CM1) in which the wordline interconnection lines (WLM) are provided, and
wherein the circuit semiconductor layer (220) comprises:
a circuit element layer (221) comprising semiconductor components of the plurality of sub-wordline drivers (SWD); and
a circuit interconnection layer (222) comprising interconnection lines electrically connecting the semiconductor components.

6. The memory device of any of claims 3-5, wherein each of the plurality of unit areas (UA) further comprises a plurality of bitline sense amplifiers (BLSA), and
wherein the plurality of bitline sense amplifiers (BLSA) are connected to bitlines (BL) connected to the plurality of memory cells (MC) through bitline interconnection lines formed in an interconnection layer on a same level as the wordline interconnection lines (WLM).

7. The memory device of any preceding claim, wherein the cell semiconductor layer (210) further comprises:
a dummy region (DUM) spaced apart from an edge odd sub-cell region (MAT_OE), among the plurality of sub-cell regions (MAT), in the first direction;
an edge contact region (ECON) between the edge odd sub-cell region (MAT_OE) and the dummy region (DUM); and
edge wordline interconnection lines (EWLM) overlapping the dummy region (DUM) and the edge contact region (ECON), and connected to even sub-wordlines (WL_E) of the edge odd sub-cell region (MAT_OE), in the edge contact region (ECON),
wherein the circuit semiconductor layer (220) further comprises an edge circuit region (EA) overlapping the dummy region (DUM) in the third direction and comprising edge sub-wordline drivers (SWD_EE), and
wherein the edge sub-wordline drivers (SWD_EE) are connected to the edge wordline interconnection lines (EWLM).

8. The memory device of any of claims 1-6, wherein the cell semiconductor layer (210) further comprises an edge contact region (ECON) which is adjacent to an edge odd sub-cell region (MAT_OE), among the plurality of sub-cell regions (MAT), in the first direction, and which is provided in an opposite direction of an adjacent contact region (CON) among the plurality of contact regions (CON),
wherein the edge odd sub-cell region (MAT_OE) further comprises edge wordline interconnection lines (EWLM) connected to even sub-wordlines (WL_E) of the edge odd sub-cell region (MAT_OE), and
wherein the circuit semiconductor layer (220) further comprises edge sub-wordline drivers (SWD_EE) overlapping the edge odd sub-cell region (MAT_OE) in the third direction and connected to the edge wordline interconnection lines (EWLM).

9. The memory device of claim 8, wherein in the first direction, a length of the edge wordline interconnection lines (EWLM) is shorter than a sum of a length of the edge contact region (ECON) and a length of the edge odd sub-cell region (MAT_OE).

10. The memory device of any of claims 1-6, wherein the cell semiconductor layer (210) further comprises an edge contact region (ECON) which is adjacent to an edge odd sub-cell region (MAT_OE), among the plurality of sub-cell regions (MAT), in the first direction, and which is provided in an opposite direction of an adjacent contact region (CON) among the plurality of contact regions (CON),
wherein the edge odd sub-cell region (MAT_OE) comprises:
a first edge wordline interconnection line extending from a first even wordline interconnection line of an adjacent even sub-cell region (MAT_E) to the edge contact region (ECON), wherein the first edge wordline interconnection line is connected to a first even sub-wordline (WL_E1) of the edge odd sub-cell region (MAT_OE); and
a second edge wordline interconnection line spaced apart from a second wordline interconnection line of the adjacent even sub-cell region (MAT_E), wherein the second edge wordline interconnection line is connected to a second even sub-wordline (WL_E4) of the edge odd sub-cell region (MAT_OE) in the adjacent contact region (CON), and
wherein the circuit semiconductor layer further comprises an edge sub-wordline driver (SWD_EE) overlapping the edge odd sub-cell region (MAT_OE) in the third direction, and connected to the second edge wordline interconnection line.

11. The memory device of claim 10, wherein in the first direction, a length of the second edge wordline interconnection line is shorter than a sum of a length of the edge contact region (ECON) and a length of the edge odd sub-cell region (MAT_OE).

12. The memory device of claim 10 or claim 11, wherein the circuit semiconductor layer (220) comprises a plurality of edge sub-wordline drivers (SWD_EE), the plurality of edge sub-wordline drivers (SWD_EE) comprising the edge sub-wordline driver (SWD_EE), and
wherein a number of the plurality of edge sub-wordline drivers (SWD_EE) is less than a number of even sub-wordlines (WL_E) in the edge odd sub-cell region (MAT_OE).

13. The memory device of any preceding claim, wherein the sub-wordlines (WL) aligned in the first direction in the plurality of sub-cell regions (MAT) are connected to each other.

14. The memory device of any preceding claim, wherein the memory device has a Cell on Periphery structure in which the cell semiconductor layer (210) is on the circuit semiconductor layer (220).

15. The memory device of any of claims 1-13, wherein the memory device has a Periphery on Cell structure in which the circuit semiconductor layer (220) is on the cell semiconductor layer (210).

## Amended claims

### Amended claims in accordance with Rule 137(2) EPC.

1. A memory device, comprising:
a cell semiconductor layer (210) respectively comprising a plurality of sub-cell regions (MAT) arranged in a first direction, and a plurality of contact regions (CON) between the plurality of sub-cell regions (MAT), wherein the plurality of sub-cell regions (MAT) comprise a plurality of memory cells (MC); and
a circuit semiconductor layer (220) stacked with the cell semiconductor layer (210) and comprising a circuit configured to control the plurality of memory cells (MC),
wherein the cell semiconductor layer (210) comprises:
sub-wordlines (SWL) extending in the first direction from the plurality of sub-cell regions (MAT) to adjacent contact regions (CON) on both sides of the sub-cell region (MAT) in the first direction, wherein the sub-wordlines (SWL) are spaced apart along a second direction intersecting the first direction; and
wordline interconnection lines (WLM), and
wherein the wordline interconnection lines (WLM) comprise:
odd wordline interconnection lines (WLM_O) extending from an odd sub-cell region (MAT_O), among the plurality of sub-cell regions (MAT), to the adjacent contact regions (CON), the odd wordline interconnection lines (WLM_O) overlapping, in a third direction, odd sub-wordlines (WL_O) in the odd sub-cell region (MAT_O) and odd sub-wordlines (WL_O) in the adjacent contact regions (CON), wherein the odd wordline interconnection lines (WLM_O) are not disposed in the even sub-cell regions (MAT_E) adjacent to the odd sub-cell region (MAT_O) in the first direction, and wherein the third direction intersects the first direction and the second direction; and
even wordline interconnection lines (WLM_E) extending from an even sub-cell region (MAT_E), among the plurality of sub-cell regions (MAT), to the adjacent contact regions (CON), the even wordline interconnection lines (WLM_E) overlapping, in the third direction, even sub-wordlines (WL_E) in the even sub-cell region (MAT_E) and even sub-wordlines (WL_E) in the adjacent contact regions (CON), wherein the even wordline interconnection lines (WLM_E) are not disposed in the odd sub-cell regions (MAT_O) adjacent to the even sub-cell region (MAT_E) in the first direction.

2. The memory device of claim 1, wherein the cell semiconductor layer (210) comprises contacts connecting the odd wordline interconnection lines (WLM_O) to the overlapping odd sub-wordlines (WL_O), and contacts connecting the even wordline interconnection lines (WLM_E) to the overlapping even sub-wordlines (WL_E) in the plurality of contact regions (CON).

3. The memory device of claim 1 or claim 2, wherein the circuit semiconductor layer (220) comprises a plurality of unit areas (UA) overlapping the plurality of sub-cell regions (MAT) in the third direction, and
wherein each of the plurality of unit areas comprises (UA) a plurality of sub-wordline drivers (SWD).

4. The memory device of claim 3, wherein each of the plurality of sub-wordline drivers (SWD) is connected to a corresponding wordline interconnection line (WLM) overlapping a corresponding sub-cell region (MAT).

5. The memory device of claim 3 or claim 4, wherein the cell semiconductor layer (210) comprises:
a cell structure layer (211) comprising the plurality of memory cells (MC) and the sub-wordlines (WL); and
a cell interconnection layer (212) comprising a first interconnection layer (CM1) in which the wordline interconnection lines (WLM) are provided, and
wherein the circuit semiconductor layer (220) comprises:
a circuit element layer (221) comprising semiconductor components of the plurality of sub-wordline drivers (SWD); and
a circuit interconnection layer (222) comprising interconnection lines electrically connecting the semiconductor components.

6. The memory device of any of claims 3-5, wherein each of the plurality of unit areas (UA) further comprises a plurality of bitline sense amplifiers (BLSA), and
wherein the plurality of bitline sense amplifiers (BLSA) are connected to bitlines (BL) connected to the plurality of memory cells (MC) through bitline interconnection lines formed in an interconnection layer on a same level as the wordline interconnection lines (WLM).

7. The memory device of any preceding claim, wherein the cell semiconductor layer (210) further comprises:
a dummy region (DUM) spaced apart from an edge odd sub-cell region (MAT_OE), among the plurality of sub-cell regions (MAT), in the first direction;
an edge contact region (ECON) between the edge odd sub-cell region (MAT_OE) and the dummy region (DUM); and
edge wordline interconnection lines (EWLM) overlapping the dummy region (DUM) and the edge contact region (ECON), and connected to even sub-wordlines (WL_E) of the edge odd sub-cell region (MAT_OE), in the edge contact region (ECON),
wherein the circuit semiconductor layer (220) further comprises an edge circuit region (EA) overlapping the dummy region (DUM) in the third direction and comprising edge sub-wordline drivers (SWD_EE), and
wherein the edge sub-wordline drivers (SWD_EE) are connected to the edge wordline interconnection lines (EWLM).

8. The memory device of any of claims 1-6, wherein the cell semiconductor layer (210) further comprises an edge contact region (ECON) which is adjacent to an edge odd sub-cell region (MAT_OE), among the plurality of sub-cell regions (MAT), in the first direction, and which is provided in an opposite direction of an adjacent contact region (CON) among the plurality of contact regions (CON),
wherein the edge odd sub-cell region (MAT_OE) further comprises edge wordline interconnection lines (EWLM) connected to even sub-wordlines (WL_E) of the edge odd sub-cell region (MAT_OE), and
wherein the circuit semiconductor layer (220) further comprises edge sub-wordline drivers (SWD_EE) overlapping the edge odd sub-cell region (MAT_OE) in the third direction and connected to the edge wordline interconnection lines (EWLM).

9. The memory device of claim 8, wherein in the first direction, a length of the edge wordline interconnection lines (EWLM) is shorter than a sum of a length of the edge contact region (ECON) and a length of the edge odd sub-cell region (MAT_OE).

10. The memory device of any of claims 1-6, wherein the cell semiconductor layer (210) further comprises an edge contact region (ECON) which is adjacent to an edge odd sub-cell region (MAT_OE), among the plurality of sub-cell regions (MAT), in the first direction, and which is provided in an opposite direction of an adjacent contact region (CON) among the plurality of contact regions (CON),
wherein the edge odd sub-cell region (MAT_OE) comprises:
a first edge wordline interconnection line extending from a first even wordline interconnection line of an adjacent even sub-cell region (MAT_E) to the edge contact region (ECON), wherein the first edge wordline interconnection line is connected to a first even sub-wordline (WL_E1) of the edge odd sub-cell region (MAT_OE); and
a second edge wordline interconnection line spaced apart from a second wordline interconnection line of the adjacent even sub-cell region (MAT_E), wherein the second edge wordline interconnection line is connected to a second even sub-wordline (WL_E4) of the edge odd sub-cell region (MAT_OE) in the adjacent contact region (CON), and
wherein the circuit semiconductor layer further comprises an edge sub-wordline driver (SWD_EE) overlapping the edge odd sub-cell region (MAT_OE) in the third direction, and connected to the second edge wordline interconnection line.

11. The memory device of claim 10, wherein in the first direction, a length of the second edge wordline interconnection line is shorter than a sum of a length of the edge contact region (ECON) and a length of the edge odd sub-cell region (MAT_OE).

12. The memory device of claim 10 or claim 11, wherein the circuit semiconductor layer (220) comprises a plurality of edge sub-wordline drivers (SWD_EE), the plurality of edge sub-wordline drivers (SWD_EE) comprising the edge sub-wordline driver (SWD_EE), and
wherein a number of the plurality of edge sub-wordline drivers (SWD_EE) is less than a number of even sub-wordlines (WL_E) in the edge odd sub-cell region (MAT_OE).

13. The memory device of any preceding claim, wherein the sub-wordlines (WL) aligned in the first direction in the plurality of sub-cell regions (MAT) are connected to each other.

14. The memory device of any preceding claim, wherein the memory device has a Cell on Periphery structure in which the cell semiconductor layer (210) is on the circuit semiconductor layer (220).

15. The memory device of any of claims 1-13, wherein the memory device has a Periphery on Cell structure in which the circuit semiconductor layer (220) is on the cell semiconductor layer (210).
